# EUROPEAN PATENT APPLICATION

(11) **EP 4 718 957 A1**
(43) Date of publication of application: **01.04.2026**
(21) Application number: 25196626.3
(22) Date of filing: 19.08.2025
(51) Int. Cl.: H05K 7/10

(54) **PROTRUSIONS OF SOCKET BODIES HAVING METAL**

(30) Priority: 26.09.2024 US 202418897941
(71) Applicant: Intel Corporation, Santa Clara, CA 95054 (US)
(72) Inventor: CANHAM, Richard, West Richland, 99353 (US); BUDDRIUS, Eric W., Hillsboro, 97123 (US); SMALLEY, Jeffory L., East Olympia, 98540 (US); PAUWELS, Garrett Frans, Beaverton, 97003 (US); FREY, Emery Evon, Portland, 97229 (US); KLEIN, Steven Adam, Chandler, 85224 (US); NEUMANN, Daniel, Tualatin, 97062 (US)
(74) Representative: Maiwald GmbH

(57) **Abstract**

Protrusions of socket bodies having metal are disclosed. An example apparatus comprises a socket body, the socket body including a plastic material, an array of contacts distributed across a surface of the socket body, and a protrusion extending away from the surface of the socket body, the protrusion to facilitate alignment of an IC package with the array of contacts, the protrusion including metal.

## Description

### BACKGROUND

Some integrated circuit (IC) packages (e.g., CPUs, GPUs, microprocessors, etc.) are mechanically and electrically connected to a circuit board via a socket coupled to the circuit board. Sockets include an array of contacts (e.g., pins) that interface with corresponding contacts (e.g., pads) on the IC package when the package is inserted into the socket. Socket types include pin grid array (PGA), land grid array (LGA), ball grid array (BGA), stud grid array (SGA), staggered pin array (SPGA), and reduced pin grid array (rPGA), among others. In some examples, an IC package contacts the socket when the IC package is inserted into the socket.

### BRIEF DESCRIPTION OF THE DRAWINGS

FIG. 1 illustrates one or more example environments in which teachings of this disclosure may be implemented.
FIG. 2 illustrates at least one example of a data center for executing workloads with disaggregated resources.
FIG. 3 illustrates at least one example of a pod that may be included in the data center of FIG. 2.
FIG. 4 is a perspective view of at least one example of a rack that may be included in the pod of FIG. 3.
FIG. 5 is a side elevation view of the rack of FIG. 4.
FIG. 6 is a perspective view of the rack of FIG. 4 having a sled mounted therein.
FIG. 7 is a is a block diagram of at least one example of a top side of the sled of FIG. 6.
FIG. 8 is a block diagram of at least one example of a bottom side of the sled of FIG. 7.
FIG. 9 is a block diagram of at least one example of a compute sled usable in the data center of FIG. 2.
FIG. 10 is a top perspective view of at least one example of the compute sled of FIG. 9.
FIG. 11 is a block diagram of at least one example of an accelerator sled usable in the data center of FIG. 2.
FIG. 12 is a top perspective view of at least one example of the accelerator sled of FIG. 11.
FIG. 13 is a block diagram of at least one example of a storage sled usable in the data center of FIG. 2.
FIG. 14 is a top perspective view of at least one example of the storage sled of FIG. 13.
FIG. 15 is a block diagram of at least one example of a memory sled usable in the data center of FIG. 2.
FIG. 16 is a block diagram of a system that may be established within the data center of FIG. 2 to execute workloads with managed nodes of disaggregated resources.
FIG. 17 is an exploded view of an example integrated circuit (IC) package heat dissipating component stack in which examples disclosed herein may be implemented.
FIG. 18A illustrates an example metal component constructed in accordance with teachings of this disclosure.
FIG. 18B illustrates an example socket body constructed in accordance with teachings of this disclosure.
FIGS. 18C-18D are detailed views of an example protrusion of the socket body of FIG. 18B.
FIG. 18E is an exploded view of the example protrusion of FIGS. 18C-18D.
FIG. 18F is an assembled view of the example protrusion of FIGS. 18C-18E and an example IC package.
FIGS. 19A-19C illustrate another example protrusion of an example socket body constructed in accordance with examples disclosed herein.
FIG. 20A is an exploded view of an example assembly constructed in accordance with examples disclosed herein.
FIG. 20B is an assembled, side view of an example protrusion of the assembly of FIG. 20A.
FIG. 21 is an exploded view of another example assembly constructed in accordance with examples disclosed herein.
FIG. 22 illustrates an example metal post constructed in accordance with examples disclosed herein.
FIG. 23 illustrates a partially assembled view of an example assembly constructed in accordance with examples disclosed herein.
FIG. 24 illustrates an example socket body constructed in accordance with examples disclosed herein.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

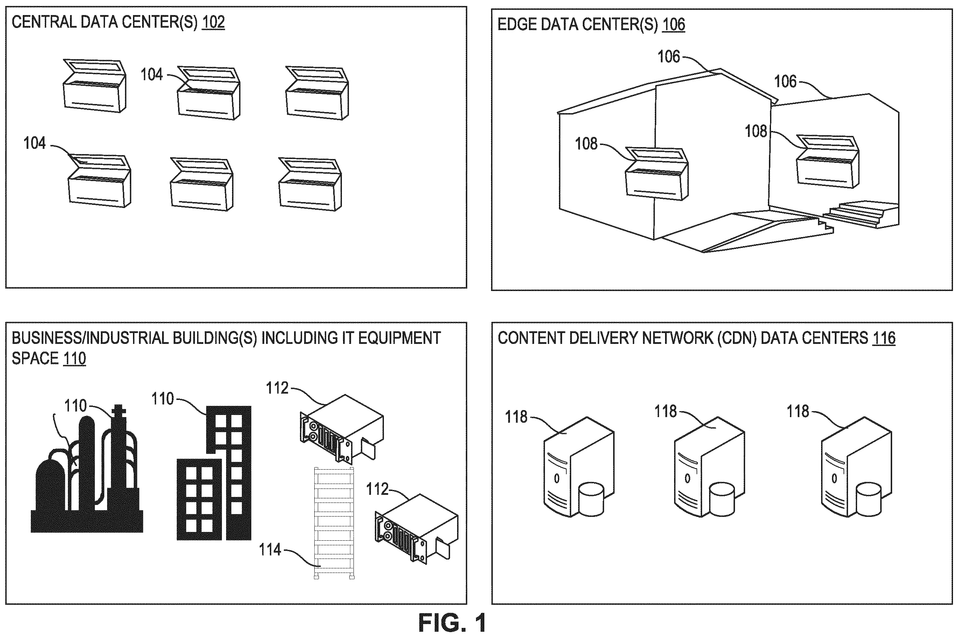

FIG. 1 illustrates one or more example environments in which teachings of this disclosure may be implemented. The example environment(s) of FIG. 1 can include one or more central data centers 102. The central data center(s) 102 can store a large number of servers used by, for instance, one or more organizations for data processing, storage, etc. As illustrated in FIG. 1, the central data center(s) 102 include a plurality of immersion tank(s) 104 to facilitate cooling of the servers and/or other electronic components stored at the central data center(s) 102. The immersion tank(s) 104 can provide for single-phase cooling or two-phase cooling.

The example environments of FIG. 1 can be part of an edge computing system. For instance, the example environments of FIG. 1 can include edge data centers or micro-data centers 106. The edge data center(s) 106 can include, for example, data centers located at a base of a cell tower. In some examples, the edge data center(s) 106 are located at or near a top of a cell tower and/or other utility pole. The edge data center(s) 106 include respective housings that store server(s), where the server(s) can be in communication with, for instance, the server(s) stored at the central data center(s) 102, client devices, and/or other computing devices in the edge network. Example housings of the edge data center(s) 106 may include materials that form one or more exterior surfaces that partially or fully protect contents therein, in which protection may include weather protection, hazardous environment protection (e.g., electromagnetic interference (EMI), vibration, extreme temperatures), and/or enable submergibility. Example housings may include power circuitry to provide power for stationary and/or portable implementations, such as alternating current (AC) power inputs, direct current (DC) power inputs, AC/DC or DC/AC converter(s), power regulators, transformers, charging circuitry, batteries, wired inputs and/or wireless power inputs. As illustrated in FIG. 1, the edge data center(s) 106 can include immersion tank(s) 108 to store server(s) and/or other electronic component(s) located at the edge data center(s) 106.

The example environment(s) of FIG. 1 can include buildings 110 for purposes of business and/or industry that store information technology (IT) equipment in, for example, one or more rooms of the building(s) 110. For example, as represented in FIG. 1, server(s) 112 can be stored with server rack(s) 114 that support the server(s) 112 (e.g., in an opening of slot of the rack 114). In some examples, the server(s) 112 located at the buildings 110 include on-premise server(s) of an edge computing network, where the on-premise server(s) are in communication with remote server(s) (e.g., the server(s) at the edge data center(s) 106) and/or other computing device(s) within an edge network.

The example environment(s) of FIG. 1 include content delivery network (CDN) data center(s) 116. The CDN data center(s) 116 of this example include server(s) 118 that cache content such as images, webpages, videos, etc. accessed via user devices. The server(s) 118 of the CDN data centers 116 can be disposed in immersion cooling tank(s) such as the immersion tanks 104, 108 shown in connection with the data centers 102, 106.

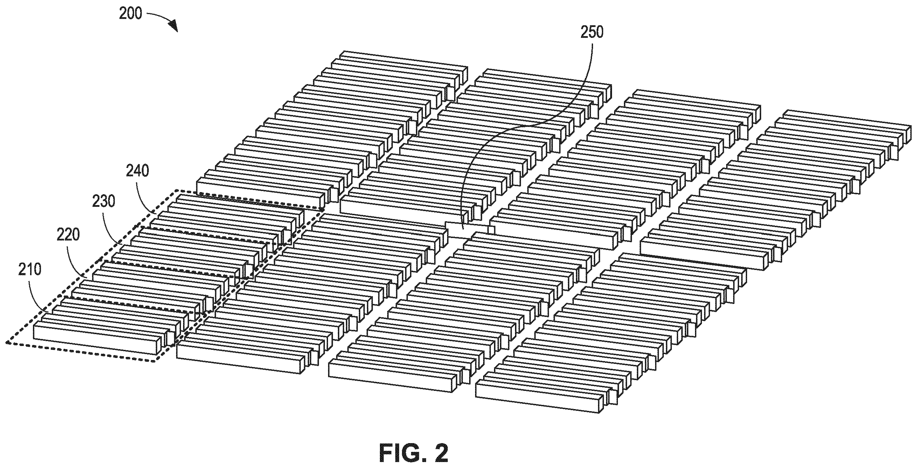

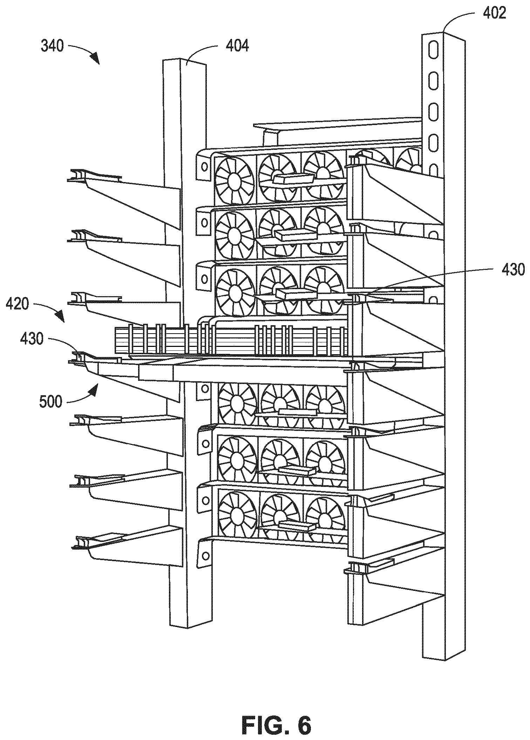

In some instances, the example data centers 102, 106, 116 and/or building(s) 110 of FIG. 1 include servers and/or other electronic components that are cooled independent of immersion tanks (e.g., the immersion tanks 104, 108) and/or an associated immersion cooling system. That is, in some examples, some or all of the servers and/or other electronic components in the data centers 102, 106, 116 and/or building(s) 110 can be cooled by air and/or liquid coolants without immersing the servers and/or other electronic components therein. Thus, in some examples, the immersion tanks 104, 108 of FIG. 1 may be omitted. Further, the example data centers 102, 106, 116 and/or building(s) 110 of FIG. 1 can correspond to, be implemented by, and/or be adaptations of the example data center 200 described in further detail below in connection with FIGS. 2-16.

Although a certain number of cooling tank(s) and other component(s) are shown in the figures, any number of such components may be present. Also, the example cooling data centers and/or other structures or environments disclosed herein are not limited to arrangements of the size that are depicted in FIG. 1. For instance, the structures containing example cooling systems and/or components thereof disclosed herein can be of a size that includes an opening to accommodate service personnel, such as the example data center(s) 106 of FIG. 1, but can also be smaller (e.g., a "doghouse" enclosure). For instance, the structures containing example cooling systems and/or components thereof disclosed herein can be sized such that access (e.g., the only access) to an interior of the structure is a port for service personnel to reach into the structure. In some examples, the structures containing example cooling systems and/or components thereof disclosed herein can be sized such that only a tool can reach into the enclosure because the structure may be supported by, for a utility pole or radio tower, or a larger structure. In addition to or as an alternative to the immersion tanks 104, 108, any of the example environments of FIG. 1 can utilize one or more liquid cooling systems having a cold plate to control the temperature of the electronic devices/components in the example environments.

FIG. 2 illustrates an example data center 200 in which disaggregated resources may cooperatively execute one or more workloads (e.g., applications on behalf of customers). The illustrated data center 200 includes multiple platforms 210, 220, 230, 240 (referred to herein as pods), each of which includes one or more rows of racks. Although the data center 200 is shown with multiple pods, in some examples, the data center 200 may be implemented as a single pod. As described in more detail herein, a rack may house multiple sleds. A sled may be primarily equipped with a particular type of resource (e.g., memory devices, data storage devices, accelerator devices, general purpose programmable circuitry) that can be logically coupled to form a composed node. Some such nodes may act as, for example, a server. In the illustrative example, the sleds in the pods 210, 220, 230, 240 are connected to multiple pod switches (e.g., switches that route data communications to and from sleds within the pod). The pod switches, in turn, connect with spine switches 250 that switch communications among pods (e.g., the pods 210, 220, 230, 240) in the data center 200. In some examples, the sleds may be connected with a fabric using Intel Omni-Path^{™} technology. In other examples, the sleds may be connected with other fabrics, such as InfiniBand or Ethernet. As described in more detail herein, resources within the sleds in the data center 200 may be allocated to a group (referred to herein as a "managed node") containing resources from one or more sleds to be collectively utilized in the execution of a workload. The workload can execute as if the resources belonging to the managed node were located on the same sled. The resources in a managed node may belong to sleds belonging to different racks, and even to different pods 210, 220, 230, 240. As such, some resources of a single sled may be allocated to one managed node while other resources of the same sled are allocated to a different managed node (e.g., first programmable circuitry assigned to one managed node and second programmable circuitry of the same sled assigned to a different managed node).

A data center including disaggregated resources, such as the data center 200, can be used in a wide variety of contexts, such as enterprise, government, cloud service provider, and communications service provider (e.g., a telecommunications provider, a telephone company (e.g., a Telco), as well in a wide variety of sizes, from cloud service provider mega-data centers that consume over 200,000 sq. ft. to single- or multi-rack installations for use in base stations.

In some examples, the disaggregation of resources is accomplished by using individual sleds that include predominantly a single type of resource (e.g., compute sleds including primarily compute resources, memory sleds including primarily memory resources). The disaggregation of resources in this manner, and the selective allocation and deallocation of the disaggregated resources to form a managed node assigned to execute a workload, improves the operation and resource usage of the data center 200 relative to typical data centers. Such typical data centers include hyperconverged servers containing compute, memory, storage and perhaps additional resources in a single chassis. For example, because a given sled will contain mostly resources of a same particular type, resources of that type can be upgraded independently of other resources. Additionally, because different resource types (programmable circuitry, storage, accelerators, etc.) typically have different refresh rates, greater resource utilization and reduced total cost of ownership may be achieved. For example, a data center operator can upgrade the programmable circuitry throughout a facility by only swapping out the compute sleds. In such a case, accelerator and storage resources may not be contemporaneously upgraded and, rather, may be allowed to continue operating until those resources are scheduled for their own refresh. Resource utilization may also increase. For example, if managed nodes are composed based on requirements of the workloads that will be running on them, resources within a node are more likely to be fully utilized. Such utilization may allow for more managed nodes to run in a data center with a given set of resources, or for a data center expected to run a given set of workloads, to be built using fewer resources.

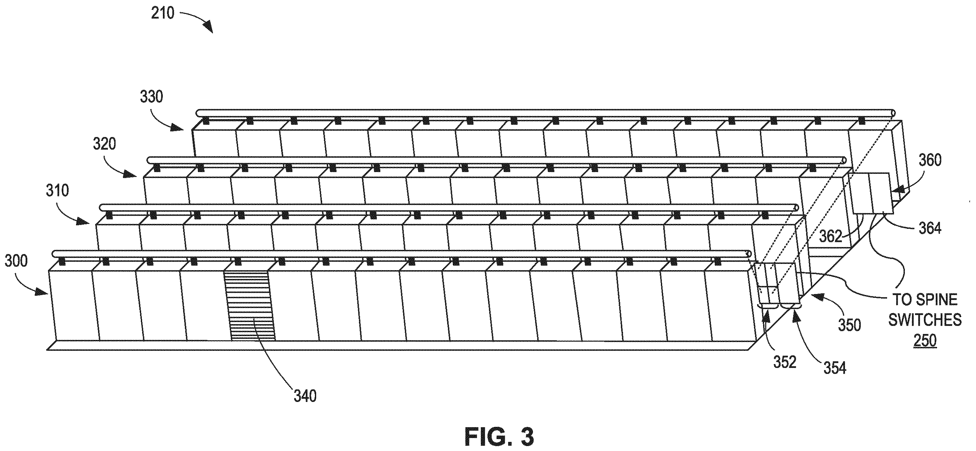

Referring now to FIG. 3, the pod 210, in the illustrative example, includes a set of rows 300, 310, 320, 330 of racks 340. Individual ones of the racks 340 may house multiple sleds (e.g., sixteen sleds) and provide power and data connections to the housed sleds, as described in more detail herein. In the illustrative example, the racks are connected to multiple pod switches 350, 360. The pod switch 350 includes a set of ports 352 to which the sleds of the racks of the pod 210 are connected and another set of ports 354 that connect the pod 210 to the spine switches 250 to provide connectivity to other pods in the data center 200. Similarly, the pod switch 360 includes a set of ports 362 to which the sleds of the racks of the pod 210 are connected and a set of ports 364 that connect the pod 210 to the spine switches 250. As such, the use of the pair of switches 350, 360 provides an amount of redundancy to the pod 210. For example, if either of the switches 350, 360 fails, the sleds in the pod 210 may still maintain data communication with the remainder of the data center 200 (e.g., sleds of other pods) through the other switch 350, 360. Furthermore, in the illustrative example, the switches 250, 350, 360 may be implemented as dual-mode optical switches, capable of routing both Ethernet protocol communications carrying Internet Protocol (IP) packets and communications according to a second, high-performance link-layer protocol (e.g., Peripheral Component Interconnect (PCI) Express (PCIe)) via optical signaling media of an optical fabric.

It should be appreciated that any one of the other pods 220, 230, 240 (as well as any additional pods of the data center 200) may be similarly structured as, and have components similar to, the pod 210 shown in and disclosed in regard to FIG. 3 (e.g., a given pod may have rows of racks housing multiple sleds as described above). Additionally, while two pod switches 350, 360 are shown, it should be understood that in other examples, a different number of pod switches may be present, providing even more failover capacity. In other examples, pods may be arranged differently than the rows-of-racks configuration shown in FIGS. 2 and 3. For example, a pod may include multiple sets of racks arranged radially (e.g., the racks are equidistant from a center switch).

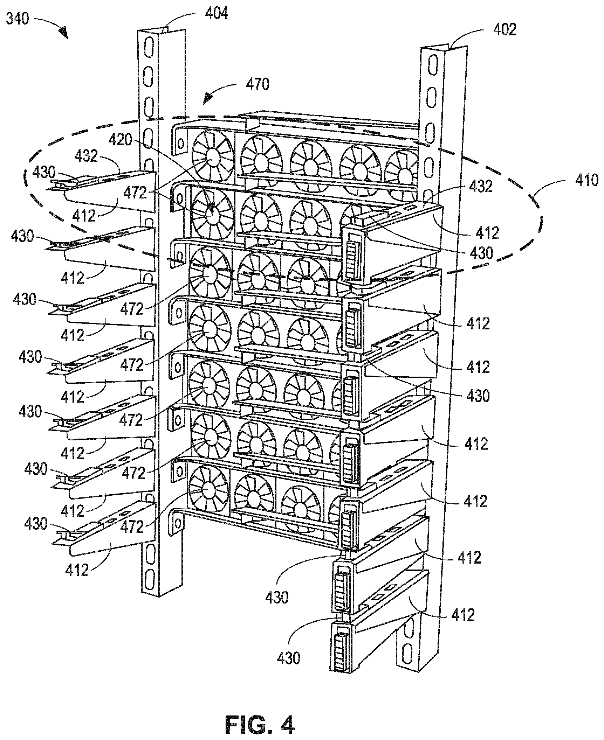

FIGS. 4-6 illustrate an example rack 340 of the data center 200. As shown in the illustrated example, the rack 340 includes two elongated support posts 402, 404, which are arranged vertically. For example, the elongated support posts 402, 404 may extend upwardly from a floor of the data center 200 when deployed. The rack 340 also includes one or more horizontal pairs 410 of elongated support arms 412 (identified in FIG. 4 via a dashed ellipse) configured to support a sled of the data center 200 as discussed below. One elongated support arm 412 of the pair of elongated support arms 412 extends outwardly from the elongated support post 402 and the other elongated support arm 412 extends outwardly from the elongated support post 404.

In the illustrative examples, at least some of the sleds of the data center 200 are chassis-less sleds. That is, such sleds have a chassis-less circuit board substrate on which physical resources (e.g., programmable circuitry, memory, accelerators, storage, etc.) are mounted as discussed in more detail below. As such, the rack 340 is configured to receive the chassis-less sleds. For example, a given pair 410 of the elongated support arms 412 defines a sled slot 420 of the rack 340, which is configured to receive a corresponding chassis-less sled. To do so, the elongated support arms 412 include corresponding circuit board guides 430 configured to receive the chassis-less circuit board substrate of the sled. The circuit board guides 430 are secured to, or otherwise mounted to, a top side 432 of the corresponding elongated support arms 412. For example, in the illustrative example, the circuit board guides 430 are mounted at a distal end of the corresponding elongated support arm 412 relative to the corresponding elongated support post 402, 404. For clarity of FIGS. 4-6, not every circuit board guide 430 may be referenced in each figure. In some examples, at least some of the sleds include a chassis and the racks 340 are suitably adapted to receive the chassis.

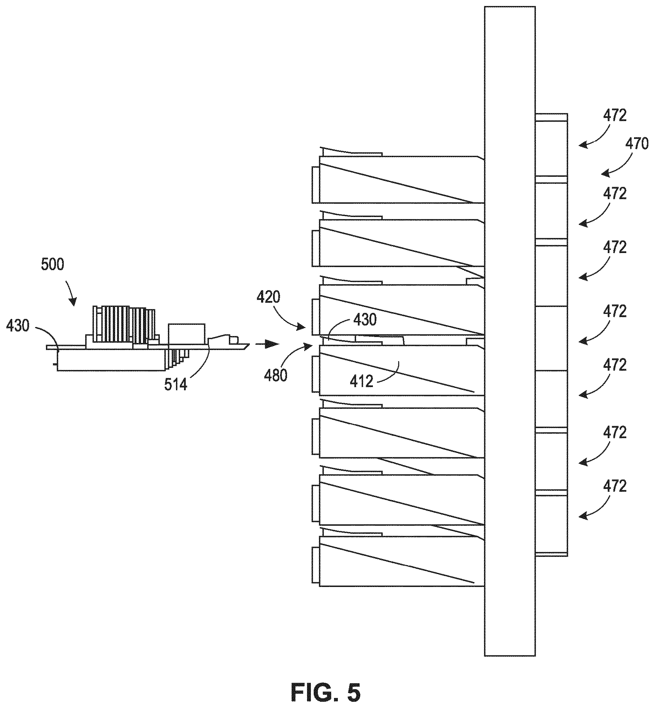

The circuit board guides 430 include an inner wall that defines a circuit board slot 480 configured to receive the chassis-less circuit board substrate of a sled 500 when the sled 500 is received in the corresponding sled slot 420 of the rack 340. To do so, as shown in FIG. 5, a user (or robot) aligns the chassis-less circuit board substrate of an illustrative chassis-less sled 500 to a sled slot 420. The user, or robot, may then slide the chassis-less circuit board substrate forward into the sled slot 420 such that each side edge 514 of the chassis-less circuit board substrate is received in a corresponding circuit board slot 480 of the circuit board guides 430 of the pair 410 of elongated support arms 412 that define the corresponding sled slot 420 as shown in FIG. 5. By having robotically accessible and robotically manipulable sleds including disaggregated resources, the different types of resource can be upgraded independently of one other and at their own optimized refresh rate. Furthermore, the sleds are configured to blindly mate with power and data communication cables in the rack 340, enhancing their ability to be quickly removed, upgraded, reinstalled, and/or replaced. As such, in some examples, the data center 200 may operate (e.g., execute workloads, undergo maintenance and/or upgrades, etc.) without human involvement on the data center floor. In other examples, a human may facilitate one or more maintenance or upgrade operations in the data center 200.

It should be appreciated that the circuit board guides 430 are dual sided. That is, a circuit board guide 430 includes an inner wall that defines a circuit board slot 480 on each side of the circuit board guide 430. In this way, the circuit board guide 430 can support a chassis-less circuit board substrate on either side. As such, a single additional elongated support post may be added to the rack 340 to turn the rack 340 into a two-rack solution that can hold twice as many sled slots 420 as shown in Fig. 4. The illustrative rack 340 includes seven pairs 410 of elongated support arms 412 that define seven corresponding sled slots 420. The sled slots 420 are configured to receive and support a corresponding sled 500 as discussed above. In other examples, the rack 340 may include additional or fewer pairs 410 of elongated support arms 412 (e.g., additional or fewer sled slots 420). It should be appreciated that because the sled 500 is chassis-less, the sled 500 may have an overall height that is different than typical servers. As such, in some examples, the height of a given sled slot 420 may be shorter than the height of a typical server (e.g., shorter than a single rank unit, referred to as "1U"). That is, the vertical distance between pairs 410 of elongated support arms 412 may be less than a standard rack unit "1U." Additionally, due to the relative decrease in height of the sled slots 420, the overall height of the rack 340 in some examples may be shorter than the height of traditional rack enclosures. For example, in some examples, the elongated support posts 402, 404 may have a length of six feet or less. Again, in other examples, the rack 340 may have different dimensions. For example, in some examples, the vertical distance between pairs 410 of elongated support arms 412 may be greater than a standard rack unit "1U". In such examples, the increased vertical distance between the sleds allows for larger heatsinks to be attached to the physical resources and for larger fans to be used (e.g., in the fan array 470 described below) for cooling the sleds, which in turn can allow the physical resources to operate at increased power levels. Further, it should be appreciated that the rack 340 does not include any walls, enclosures, or the like. Rather, the rack 340 is an enclosure-less rack that is opened to the local environment. In some cases, an end plate may be attached to one of the elongated support posts 402, 404 in those situations in which the rack 340 forms an end-of-row rack in the data center 200.

In some examples, various interconnects may be routed upwardly or downwardly through the elongated support posts 402, 404. To facilitate such routing, the elongated support posts 402, 404 include an inner wall that defines an inner chamber in which interconnects may be located. The interconnects routed through the elongated support posts 402, 404 may be implemented as any type of interconnects including, but not limited to, data or communication interconnects to provide communication connections to the sled slots 420, power interconnects to provide power to the sled slots 420, and/or other types of interconnects.

The rack 340, in the illustrative example, includes a support platform on which a corresponding optical data connector (not shown) is mounted. Such optical data connectors are associated with corresponding sled slots 420 and are configured to mate with optical data connectors of corresponding sleds 500 when the sleds 500 are received in the corresponding sled slots 420. In some examples, optical connections between components (e.g., sleds, racks, and switches) in the data center 200 are made with a blind mate optical connection. For example, a door on a given cable may prevent dust from contaminating the fiber inside the cable. In the process of connecting to a blind mate optical connector mechanism, the door is pushed open when the end of the cable approaches or enters the connector mechanism. Subsequently, the optical fiber inside the cable may enter a gel within the connector mechanism and the optical fiber of one cable comes into contact with the optical fiber of another cable within the gel inside the connector mechanism.

The illustrative rack 340 also includes a fan array 470 coupled to the cross-support arms of the rack 340. The fan array 470 includes one or more rows of cooling fans 472, which are aligned in a horizontal line between the elongated support posts 402, 404. In the illustrative example, the fan array 470 includes a row of cooling fans 472 for the different sled slots 420 of the rack 340. As discussed above, the sleds 500 do not include any on-board cooling system in the illustrative example and, as such, the fan array 470 provides cooling for such sleds 500 received in the rack 340. In other examples, some or all of the sleds 500 can include on-board cooling systems. Further, in some examples, the sleds 500 and/or the racks 340 may include and/or incorporate a liquid and/or immersion cooling system to facilitate cooling of electronic component(s) on the sleds 500. The rack 340, in the illustrative example, also includes different power supplies associated with different ones of the sled slots 420. A given power supply is secured to one of the elongated support arms 412 of the pair 410 of elongated support arms 412 that define the corresponding sled slot 420. For example, the rack 340 may include a power supply coupled or secured to individual ones of the elongated support arms 412 extending from the elongated support post 402. A given power supply includes a power connector configured to mate with a power connector of a sled 500 when the sled 500 is received in the corresponding sled slot 420. In the illustrative example, the sled 500 does not include any on-board power supply and, as such, the power supplies provided in the rack 340 supply power to corresponding sleds 500 when mounted to the rack 340. A given power supply is configured to satisfy the power requirements for its associated sled, which can differ from sled to sled. Additionally, the power supplies provided in the rack 340 can operate independent of each other. That is, within a single rack, a first power supply providing power to a compute sled can provide power levels that are different than power levels supplied by a second power supply providing power to an accelerator sled. The power supplies may be controllable at the sled level or rack level, and may be controlled locally by components on the associated sled or remotely, such as by another sled or an orchestrator.

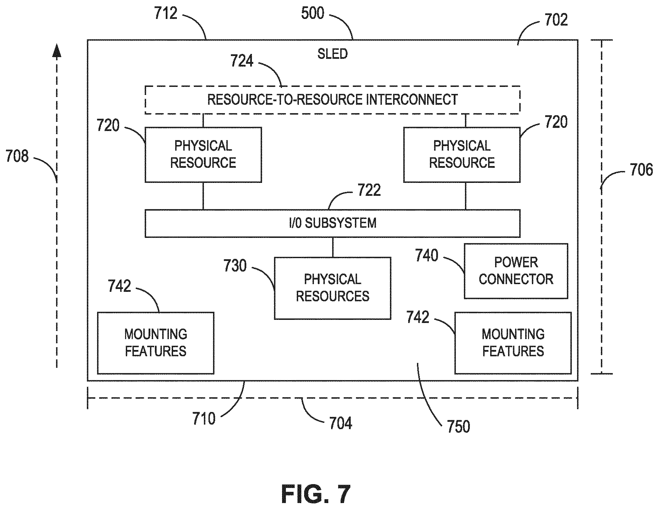

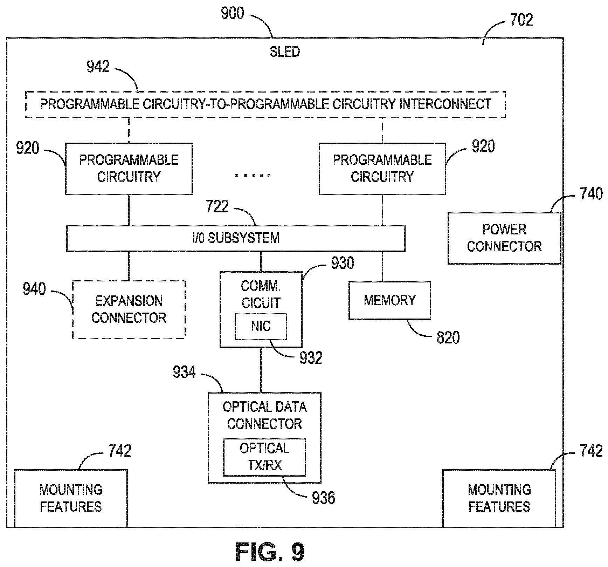

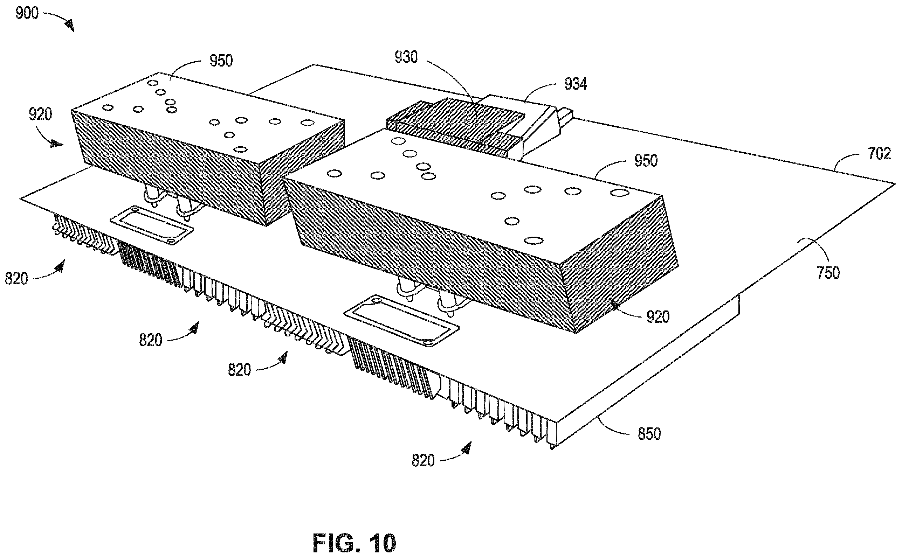

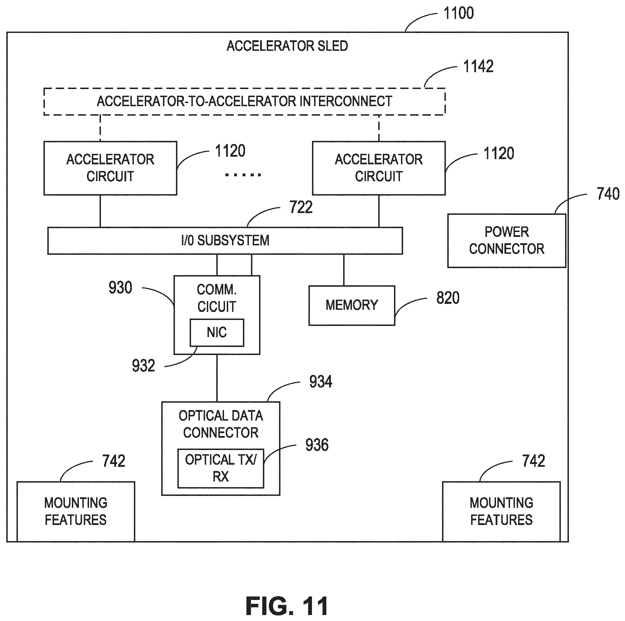

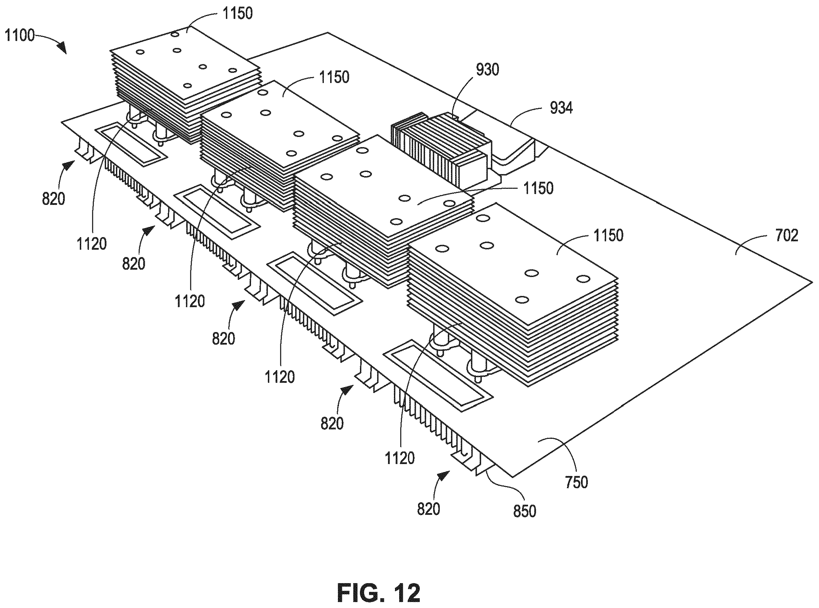

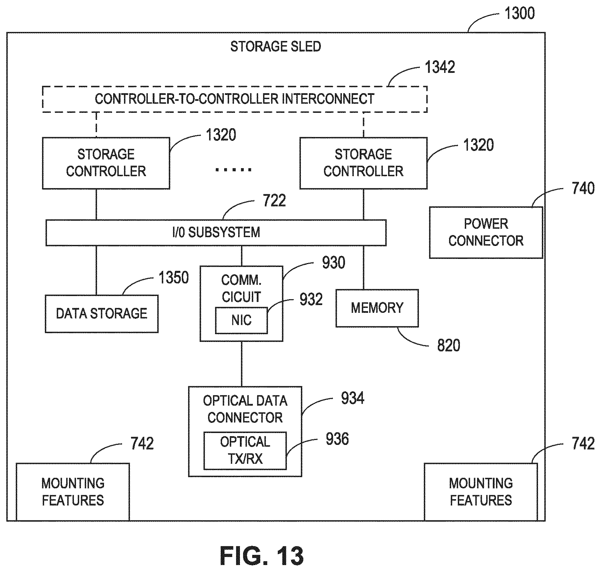

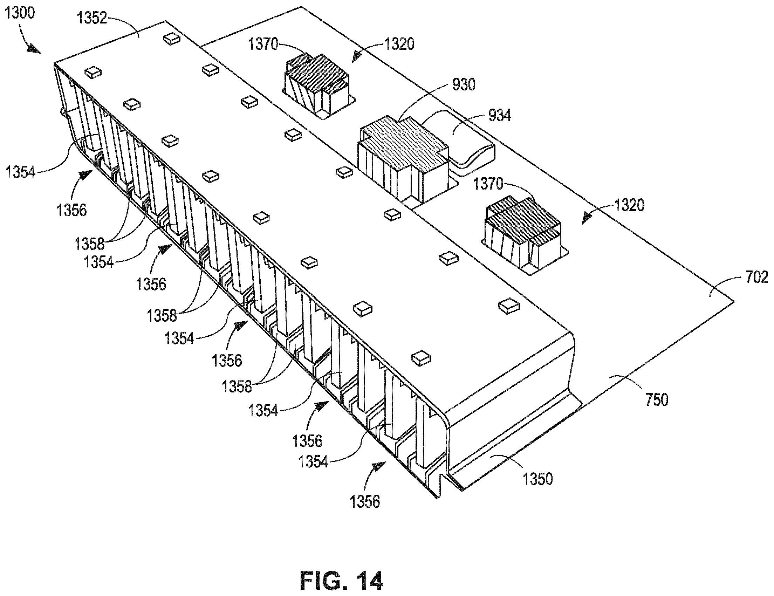

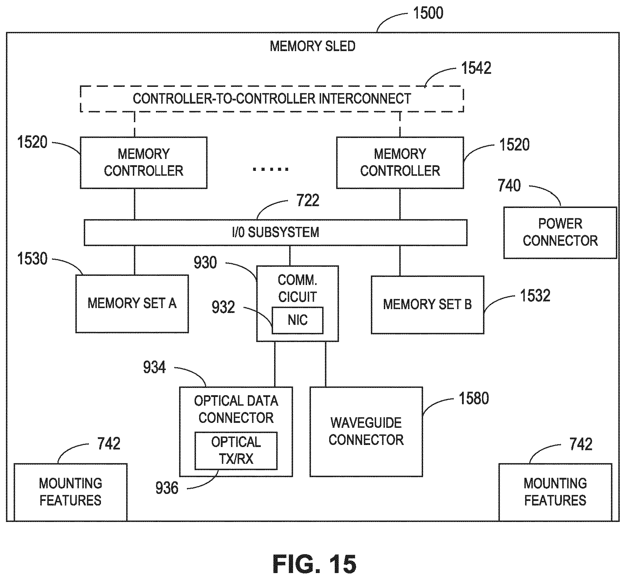

Referring now to FIG. 7, the sled 500, in the illustrative example, is configured to be mounted in a corresponding rack 340 of the data center 200 as discussed above. In some examples, a given sled 500 may be optimized or otherwise configured for performing particular tasks, such as compute tasks, acceleration tasks, data storage tasks, etc. For example, the sled 500 may be implemented as a compute sled 900 as discussed below in regard to FIGS. 9 and 10, an accelerator sled 1100 as discussed below in regard to FIGS. 11 and 12, a storage sled 1300 as discussed below in regard to FIGS. 13 and 14, or as a sled optimized or otherwise configured to perform other specialized tasks, such as a memory sled 1500, discussed below in regard to FIG. 15.

As discussed above, the illustrative sled 500 includes a chassis-less circuit board substrate 702, which supports various physical resources (e.g., electrical components) mounted thereon. It should be appreciated that the circuit board substrate 702 is "chassis-less" in that the sled 500 does not include a housing or enclosure. Rather, the chassis-less circuit board substrate 702 is open to the local environment. The chassis-less circuit board substrate 702 may be formed from any material capable of supporting the various electrical components mounted thereon. For example, in an illustrative example, the chassis-less circuit board substrate 702 is formed from an FR-4 glass-reinforced epoxy laminate material. Other materials may be used to form the chassis-less circuit board substrate 702 in other examples.

As discussed in more detail below, the chassis-less circuit board substrate 702 includes multiple features that improve the thermal cooling characteristics of the various electrical components mounted on the chassis-less circuit board substrate 702. As discussed, the chassis-less circuit board substrate 702 does not include a housing or enclosure, which may improve the airflow over the electrical components of the sled 500 by reducing those structures that may inhibit air flow. For example, because the chassis-less circuit board substrate 702 is not positioned in an individual housing or enclosure, there is no vertically-arranged backplane (e.g., a back plate of the chassis) attached to the chassis-less circuit board substrate 702, which could inhibit air flow across the electrical components. Additionally, the chassis-less circuit board substrate 702 has a geometric shape configured to reduce the length of the airflow path across the electrical components mounted to the chassis-less circuit board substrate 702. For example, the illustrative chassis-less circuit board substrate 702 has a width 704 that is greater than a depth 706 of the chassis-less circuit board substrate 702. In one particular example, the chassis-less circuit board substrate 702 has a width of about 21 inches and a depth of about 9 inches, compared to a typical server that has a width of about 17 inches and a depth of about 39 inches. As such, an airflow path 708 that extends from a front edge 710 of the chassis-less circuit board substrate 702 toward a rear edge 712 has a shorter distance relative to typical servers, which may improve the thermal cooling characteristics of the sled 500. Furthermore, although not illustrated in FIG. 7, the various physical resources mounted to the chassis-less circuit board substrate 702 in this example are mounted in corresponding locations such that no two substantively heat-producing electrical components shadow each other as discussed in more detail below. That is, no two electrical components, which produce appreciable heat during operation (e.g., greater than a nominal heat sufficient enough to adversely impact the cooling of another electrical component), are mounted to the chassis-less circuit board substrate 702 linearly in-line with each other along the direction of the airflow path 708 (e.g., along a direction extending from the front edge 710 toward the rear edge 712 of the chassis-less circuit board substrate 702). The placement and/or structure of the features may be suitable adapted when the electrical component(s) are being cooled via liquid (e.g., one phase or two phase cooling).

As discussed above, the illustrative sled 500 includes one or more physical resources 720 mounted to a top side 750 of the chassis-less circuit board substrate 702. Although two physical resources 720 are shown in FIG. 7, it should be appreciated that the sled 500 may include one, two, or more physical resources 720 in other examples. The physical resources 720 may be implemented as any type of programmable circuitry, controller, or other compute circuit capable of performing various tasks such as compute functions and/or controlling the functions of the sled 500 depending on, for example, the type or intended functionality of the sled 500. For example, as discussed in more detail below, the physical resources 720 may be implemented as high-performance processor circuitry in examples in which the sled 500 is implemented as a compute sled, as accelerator co-processor circuitry or circuits in examples in which the sled 500 is implemented as an accelerator sled, storage controllers in examples in which the sled 500 is implemented as a storage sled, or a set of memory devices in examples in which the sled 500 is implemented as a memory sled.

The sled 500 also includes one or more additional physical resources 730 mounted to the top side 750 of the chassis-less circuit board substrate 702. In the illustrative example, the additional physical resources include a network interface controller (NIC) as discussed in more detail below. Depending on the type and functionality of the sled 500, the physical resources 730 may include additional or other electrical components, circuits, and/or devices in other examples.

The physical resources 720 are communicatively coupled to the physical resources 730 via an input/output (I/O) subsystem 722. The I/O subsystem 722 may be implemented as circuitry and/or components to facilitate input/output operations with the physical resources 720, the physical resources 730, and/or other components of the sled 500. For example, the I/O subsystem 722 may be implemented as, or otherwise include, memory controller hubs, input/output control hubs, integrated sensor hubs, firmware devices, communication links (e.g., point-to-point links, bus links, wires, cables, waveguides, light guides, printed circuit board traces, etc.), and/or other components and subsystems to facilitate the input/output operations. In the illustrative example, the I/O subsystem 722 is implemented as, or otherwise includes, a double data rate (DDR) data bus such as a DDR4 data bus or a DDR5 data bus.

In some examples, the sled 500 may also include a resource-to-resource interconnect 724. The resource-to-resource interconnect 724 may be implemented as any type of communication interconnect capable of facilitating resource-to-resource communications. In the illustrative example, the resource-to-resource interconnect 724 is implemented as a high-speed point-to-point interconnect (e.g., faster than the I/O subsystem 722). For example, the resource-to-resource interconnect 724 may be implemented as a QuickPath Interconnect (QPI), an UltraPath Interconnect (UPI), or other high-speed point-to-point interconnect dedicated to resource-to-resource communications.

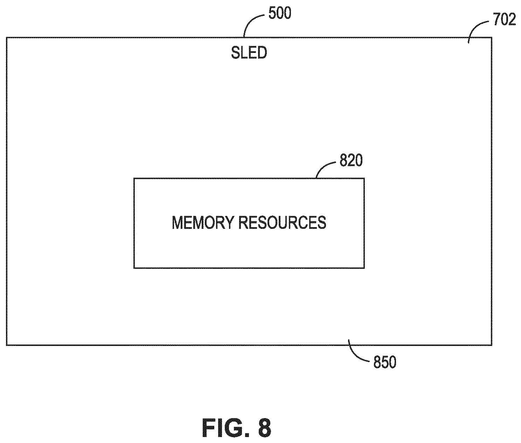

The sled 500 also includes a power connector 740 configured to mate with a corresponding power connector of the rack 340 when the sled 500 is mounted in the corresponding rack 340. The sled 500 receives power from a power supply of the rack 340 via the power connector 740 to supply power to the various electrical components of the sled 500. That is, the sled 500 does not include any local power supply (e.g., an on-board power supply) to provide power to the electrical components of the sled 500. The exclusion of a local or on-board power supply facilitates the reduction in the overall footprint of the chassis-less circuit board substrate 702, which may increase the thermal cooling characteristics of the various electrical components mounted on the chassis-less circuit board substrate 702 as discussed above. In some examples, voltage regulators are placed on a bottom side 850 (see FIG. 8) of the chassis-less circuit board substrate 702 directly opposite of programmable circuitry 920 (see FIG. 9), and power is routed from the voltage regulators to the programmable circuitry 920 by vias extending through the circuit board substrate 702. Such a configuration provides an increased thermal budget, additional current and/or voltage, and better voltage control relative to typical printed circuit boards in which processor power is delivered from a voltage regulator, in part, by printed circuit traces.

In some examples, the sled 500 may also include mounting features 742 configured to mate with a mounting arm, or other structure, of a robot to facilitate the placement of the sled 500 in a rack 340 by the robot. The mounting features 742 may be implemented as any type of physical structures that allow the robot to grasp the sled 500 without damaging the chassis-less circuit board substrate 702 or the electrical components mounted thereto. For example, in some examples, the mounting features 742 may be implemented as non-conductive pads attached to the chassis-less circuit board substrate 702. In other examples, the mounting features may be implemented as brackets, braces, or other similar structures attached to the chassis-less circuit board substrate 702. The particular number, shape, size, and/or make-up of the mounting feature 742 may depend on the design of the robot configured to manage the sled 500.

Referring now to FIG. 8, in addition to the physical resources 730 mounted on the top side 750 of the chassis-less circuit board substrate 702, the sled 500 also includes one or more memory devices 820 mounted to a bottom side 850 of the chassis-less circuit board substrate 702. That is, the chassis-less circuit board substrate 702 is implemented as a double-sided circuit board. The physical resources 720 are communicatively coupled to the memory devices 820 via the I/O subsystem 722. For example, the physical resources 720 and the memory devices 820 may be communicatively coupled by one or more vias extending through the chassis-less circuit board substrate 702. Different ones of the physical resources 720 may be communicatively coupled to different sets of one or more memory devices 820 in some examples. Alternatively, in other examples, different ones of the physical resources 720 may be communicatively coupled to the same ones of the memory devices 820.

The memory devices 820 may be implemented as any type of memory device capable of storing data for the physical resources 720 during operation of the sled 500, such as any type of volatile (e.g., dynamic random access memory (DRAM), etc.) or non-volatile memory. Volatile memory may be a storage medium that requires power to maintain the state of data stored by the medium. Non-limiting examples of volatile memory may include various types of random access memory (RAM), such as dynamic random access memory (DRAM) or static random access memory (SRAM). One particular type of DRAM that may be used in a memory module is synchronous dynamic random access memory (SDRAM). In particular examples, DRAM of a memory component may comply with a standard promulgated by the Joint Electron Device Engineering Council (JEDEC) referred to as JESD, such as JESD79F for DDR SDRAM, JESD79-2F for DDR2 SDRAM, JESD79-3F for DDR3 SDRAM, JESD79-4A for DDR4 SDRAM, JESD209 for Low Power DDR (LPDDR), JESD209-2 for LPDDR2, JESD209-3 for LPDDR3, and JESD209-4 for LPDDR4. Such standards (and similar standards) may be referred to as DDR-based standards and communication interfaces of the storage devices that implement such standards may be referred to as DDR-based interfaces.

In one example, the memory device is a block addressable memory device, such as those based on NOT AND (NAND) or NOT OR (NOR) technologies. A memory device may also include next-generation nonvolatile devices, such as Intel 3D XPoint^{™} memory or other byte addressable write-in-place nonvolatile memory devices. In one example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, or a combination of any of the above, or other memory. The memory device may refer to the die itself and/or to a packaged memory product. In some examples, the memory device may include a transistor-less stackable cross point architecture in which memory cells sit at the intersection of word lines and bit lines and are individually addressable and in which bit storage is based on a change in bulk resistance.

Referring now to FIG. 9, in some examples, the sled 500 may be implemented as a compute sled 900. The compute sled 900 is optimized, or otherwise configured, to perform compute tasks. As discussed above, the compute sled 900 may rely on other sleds, such as acceleration sleds and/or storage sleds, to perform such compute tasks. The compute sled 900 includes various physical resources (e.g., electrical components) similar to the physical resources of the sled 500, which have been identified in FIG. 9 using the same reference numbers. The description of such components provided above in regard to FIGS. 7 and 8 applies to the corresponding components of the compute sled 900 and is not repeated herein for clarity of the description of the compute sled 900.

In the illustrative compute sled 900, the physical resources 720 include programmable circuitry 920. Although only two blocks of programmable circuitry 920 are shown in FIG. 9, it should be appreciated that the compute sled 900 may include additional programmable circuits 920 in other examples. Illustratively, the programmable circuitry 920 corresponds to high-performance processor circuitry 920 and may be configured to operate at a relatively high power rating. Although the high-performance programmable circuitry 920 generates additional heat operating at power ratings greater than typical processor circuitry (which operate at around 155-230 W), the enhanced thermal cooling characteristics of the chassis-less circuit board substrate 702 discussed above facilitate the higher power operation. For example, in the illustrative example, the programmable circuitry 920 is configured to operate at a power rating of at least 250 W. In some examples, the programmable circuitry 920 may be configured to operate at a power rating of at least 350 W.

In some examples, the compute sled 900 may also include a programmable circuitry-to-programmable circuitry interconnect 942. Similar to the resource-to-resource interconnect 724 of the sled 500 discussed above, the programmable circuitry -to-programmable circuitry interconnect 942 may be implemented as any type of communication interconnect capable of facilitating programmable circuitry-to-programmable circuitry interconnect 942 communications. In the illustrative example, the programmable circuitry-to-programmable circuitry interconnect 942 is implemented as a high-speed point-to-point interconnect (e.g., faster than the I/O subsystem 722). For example, the programmable circuitry-to-programmable circuitry interconnect 942 may be implemented as a QuickPath Interconnect (QPI), an UltraPath Interconnect (UPI), or other high-speed point-to-point interconnect dedicated to programmable circuitry-to-programmable circuitry communications.

The compute sled 900 also includes a communication circuit 930. The illustrative communication circuit 930 includes a network interface controller (NIC) 932, which may also be referred to as a host fabric interface (HFI). The NIC 932 may be implemented as, or otherwise include, any type of integrated circuit, discrete circuits, controller chips, chipsets, add-in-boards, daughtercards, network interface cards, or other devices that may be used by the compute sled 900 to connect with another compute device (e.g., with other sleds 500). In some examples, the NIC 932 may be implemented as part of a system-on-a-chip (SoC) that includes one or more processor circuits, or included on a multichip package that also contains one or more processor circuits. In some examples, the NIC 932 may include a local processor circuit (not shown) and/or a local memory (not shown) that are both local to the NIC 932. In such examples, the local processor circuit of the NIC 932 may be capable of performing one or more of the functions of the programmable circuitry 920. Additionally or alternatively, in such examples, the local memory of the NIC 932 may be integrated into one or more components of the compute sled at the board level, socket level, chip level, and/or other levels.

The communication circuit 930 is communicatively coupled to an optical data connector 934. The optical data connector 934 is configured to mate with a corresponding optical data connector of the rack 340 when the compute sled 900 is mounted in the rack 340. Illustratively, the optical data connector 934 includes a plurality of optical fibers which lead from a mating surface of the optical data connector 934 to an optical transceiver 936. The optical transceiver 936 is configured to convert incoming optical signals from the rack-side optical data connector to electrical signals and to convert electrical signals to outgoing optical signals to the rack-side optical data connector. Although shown as forming part of the optical data connector 934 in the illustrative example, the optical transceiver 936 may form a portion of the communication circuit 930 in other examples.

In some examples, the compute sled 900 may also include an expansion connector 940. In such examples, the expansion connector 940 is configured to mate with a corresponding connector of an expansion chassis-less circuit board substrate to provide additional physical resources to the compute sled 900. The additional physical resources may be used, for example, by the programmable circuitry 920 during operation of the compute sled 900. The expansion chassis-less circuit board substrate may be substantially similar to the chassis-less circuit board substrate 702 discussed above and may include various electrical components mounted thereto. The particular electrical components mounted to the expansion chassis-less circuit board substrate may depend on the intended functionality of the expansion chassis-less circuit board substrate. For example, the expansion chassis-less circuit board substrate may provide additional compute resources, memory resources, and/or storage resources. As such, the additional physical resources of the expansion chassis-less circuit board substrate may include, but is not limited to, processor circuitry, memory devices, storage devices, and/or accelerator circuits including, for example, field programmable gate arrays (FPGAs), application-specific integrated circuits (ASICs), security co-processor circuits, graphics processing units (GPUs), machine learning circuits, or other specialized processor circuits, controllers, devices, and/or circuits.

Referring now to FIG. 10, an illustrative example of the compute sled 900 is shown. As shown, the programmable circuitry 920, communication circuit 930, and optical data connector 934 are mounted to the top side 750 of the chassis-less circuit board substrate 702. Any suitable attachment or mounting technology may be used to mount the physical resources of the compute sled 900 to the chassis-less circuit board substrate 702. For example, the various physical resources may be mounted in corresponding sockets (e.g., a processor circuit socket), holders, or brackets. In some cases, some of the electrical components may be directly mounted to the chassis-less circuit board substrate 702 via soldering or similar techniques.

As discussed above, the separate programmable circuitry 920 and the communication circuit 930 are mounted to the top side 750 of the chassis-less circuit board substrate 702 such that no two heat-producing, electrical components shadow each other. In the illustrative example, the programmable circuitry 920 and the communication circuit 930 are mounted in corresponding locations on the top side 750 of the chassis-less circuit board substrate 702 such that no two of those physical resources are linearly in-line with others along the direction of the airflow path 708. It should be appreciated that, although the optical data connector 934 is in-line with the communication circuit 930, the optical data connector 934 produces no or nominal heat during operation.

The memory devices 820 of the compute sled 900 are mounted to the bottom side 850 of the of the chassis-less circuit board substrate 702 as discussed above in regard to the sled 500. Although mounted to the bottom side 850, the memory devices 820 are communicatively coupled to the programmable circuitry 920 located on the top side 750 via the I/O subsystem 722. Because the chassis-less circuit board substrate 702 is implemented as a double-sided circuit board, the memory devices 820 and the programmable circuitry 920 may be communicatively coupled by one or more vias, connectors, or other mechanisms extending through the chassis-less circuit board substrate 702. Different programmable circuitry 920 (e.g., different processor circuitry) may be communicatively coupled to a different set of one or more memory devices 820 in some examples. Alternatively, in other examples, different programmable circuitry 920 (e.g., different processor circuitry) may be communicatively coupled to the same ones of the memory devices 820. In some examples, the memory devices 820 may be mounted to one or more memory mezzanines on the bottom side of the chassis-less circuit board substrate 702 and may interconnect with a corresponding programmable circuitry 920 through a ball-grid array.

Different programmable circuitry 920 (e.g., different processor circuitry) include and/or is associated with corresponding heatsinks 950 secured thereto. Due to the mounting of the memory devices 820 to the bottom side 850 of the chassis-less circuit board substrate 702 (as well as the vertical spacing of the sleds 500 in the corresponding rack 340), the top side 750 of the chassis-less circuit board substrate 702 includes additional "free" area or space that facilitates the use of heatsinks 950 having a larger size relative to traditional heatsinks used in typical servers. Additionally, due to the improved thermal cooling characteristics of the chassis-less circuit board substrate 702, none of the programmable circuitry heatsinks 950 include cooling fans attached thereto. That is, the heatsinks 950 may be fan-less heatsinks. In some examples, the heatsinks 950 mounted atop the programmable circuitry 920 may overlap with the heatsink attached to the communication circuit 930 in the direction of the airflow path 708 due to their increased size, as illustratively suggested by FIG. 10.

Referring now to FIG. 11, in some examples, the sled 500 may be implemented as an accelerator sled 1100. The accelerator sled 1100 is configured to perform specialized compute tasks, such as machine learning, encryption, hashing, or other computational-intensive task. In some examples, for example, a compute sled 900 may offload tasks to the accelerator sled 1100 during operation. The accelerator sled 1100 includes various components similar to components of the sled 500 and/or the compute sled 900, which have been identified in FIG. 11 using the same reference numbers. The description of such components provided above in regard to FIGS. 7, 8, and 9 apply to the corresponding components of the accelerator sled 1100 and is not repeated herein for clarity of the description of the accelerator sled 1100.

In the illustrative accelerator sled 1100, the physical resources 720 include accelerator circuits 1120. Although only two accelerator circuits 1120 are shown in FIG. 11, it should be appreciated that the accelerator sled 1100 may include additional accelerator circuits 1120 in other examples. For example, as shown in FIG. 12, the accelerator sled 1100 may include four accelerator circuits 1120. The accelerator circuits 1120 may be implemented as any type of processor circuitry, co-processor circuitry, compute circuit, or other device capable of performing compute or processing operations. For example, the accelerator circuits 1120 may be implemented as, for example, FPGAs, ASICs, security co-processor circuitry, GPUs, neuromorphic processor units, quantum computers, machine learning circuits, or other specialized processor circuitry, controllers, devices, and/or circuits.

In some examples, the accelerator sled 1100 may also include an accelerator-to-accelerator interconnect 1142. Similar to the resource-to-resource interconnect 724 of the sled 500 discussed above, the accelerator-to-accelerator interconnect 1142 may be implemented as any type of communication interconnect capable of facilitating accelerator-to-accelerator communications. In the illustrative example, the accelerator-to-accelerator interconnect 1142 is implemented as a high-speed point-to-point interconnect (e.g., faster than the I/O subsystem 722). For example, the accelerator-to-accelerator interconnect 1142 may be implemented as a QuickPath Interconnect (QPI), an UltraPath Interconnect (UPI), or other high-speed point-to-point interconnect dedicated to programmable circuitry-to-programmable circuitry communications. In some examples, the accelerator circuits 1120 may be daisy-chained with a primary accelerator circuit 1120 connected to the NIC 932 and memory 820 through the I/O subsystem 722 and a secondary accelerator circuit 1120 connected to the NIC 932 and memory 820 through a primary accelerator circuit 1120.

Referring now to FIG. 12, an illustrative example of the accelerator sled 1100 is shown. As discussed above, the accelerator circuits 1120, the communication circuit 930, and the optical data connector 934 are mounted to the top side 750 of the chassis-less circuit board substrate 702. Again, the individual accelerator circuits 1120 and communication circuit 930 are mounted to the top side 750 of the chassis-less circuit board substrate 702 such that no two heat-producing, electrical components shadow each other as discussed above. The memory devices 820 of the accelerator sled 1100 are mounted to the bottom side 850 of the of the chassis-less circuit board substrate 702 as discussed above in regard to the sled 500. Although mounted to the bottom side 850, the memory devices 820 are communicatively coupled to the accelerator circuits 1120 located on the top side 750 via the I/O subsystem 722 (e.g., through vias). Further, the accelerator circuits 1120 may include and/or be associated with a heatsink 1150 that is larger than a traditional heatsink used in a server. As discussed above with reference to the heatsinks 950 of FIG. 9, the heatsinks 1150 may be larger than traditional heatsinks because of the "free" area provided by the memory resources 820 being located on the bottom side 850 of the chassis-less circuit board substrate 702 rather than on the top side 750.

Referring now to FIG. 13, in some examples, the sled 500 may be implemented as a storage sled 1300. The storage sled 1300 is configured to store data in a data storage 1350 local to the storage sled 1300. For example, during operation, a compute sled 900 or an accelerator sled 1100 may store and retrieve data from the data storage 1350 of the storage sled 1300. The storage sled 1300 includes various components similar to components of the sled 500 and/or the compute sled 900, which have been identified in FIG. 13 using the same reference numbers. The description of such components provided above in regard to FIGS. 7, 8, and 9 apply to the corresponding components of the storage sled 1300 and is not repeated herein for clarity of the description of the storage sled 1300.

In the illustrative storage sled 1300, the physical resources 720 includes storage controllers 1320. Although only two storage controllers 1320 are shown in FIG. 13, it should be appreciated that the storage sled 1300 may include additional storage controllers 1320 in other examples. The storage controllers 1320 may be implemented as any type of programmable circuitry, controller, or control circuit capable of controlling the storage and retrieval of data into the data storage 1350 based on requests received via the communication circuit 930. In the illustrative example, the storage controllers 1320 are implemented as relatively low-power programmable circuitry or controllers. For example, in some examples, the storage controllers 1320 may be configured to operate at a power rating of about 75 watts.

In some examples, the storage sled 1300 may also include a controller-to-controller interconnect 1342. Similar to the resource-to-resource interconnect 724 of the sled 500 discussed above, the controller-to-controller interconnect 1342 may be implemented as any type of communication interconnect capable of facilitating controller-to-controller communications. In the illustrative example, the controller-to-controller interconnect 1342 is implemented as a high-speed point-to-point interconnect (e.g., faster than the I/O subsystem 722). For example, the controller-to-controller interconnect 1342 may be implemented as a QuickPath Interconnect (QPI), an UltraPath Interconnect (UPI), or other high-speed point-to-point interconnect dedicated to programmable circuitry-to-programmable circuitry communications.

Referring now to FIG. 14, an illustrative example of the storage sled 1300 is shown. In the illustrative example, the data storage 1350 is implemented as, or otherwise includes, a storage cage 1352 configured to house one or more solid state drives (SSDs) 1354. To do so, the storage cage 1352 includes a number of mounting slots 1356, which are configured to receive corresponding solid state drives 1354. The mounting slots 1356 include a number of drive guides 1358 that cooperate to define an access opening of the corresponding mounting slot 1356. The storage cage 1352 is secured to the chassis-less circuit board substrate 702 such that the access openings face away from (e.g., toward the front of) the chassis-less circuit board substrate 702. As such, solid state drives 1354 are accessible while the storage sled 1300 is mounted in a corresponding rack 340. For example, a solid state drive 1354 may be swapped out of a rack 340 (e.g., via a robot) while the storage sled 1300 remains mounted in the corresponding rack 340.

The storage cage 1352 illustratively includes sixteen mounting slots 1356 and is capable of mounting and storing sixteen solid state drives 1354. The storage cage 1352 may be configured to store additional or fewer solid state drives 1354 in other examples. Additionally, in the illustrative example, the solid state drives are mounted vertically in the storage cage 1352, but may be mounted in the storage cage 1352 in a different orientation in other examples. A given solid state drive 1354 may be implemented as any type of data storage device capable of storing long term data. To do so, the solid state drives 1354 may include volatile and non-volatile memory devices discussed above.

As shown in FIG. 14, the storage controllers 1320, the communication circuit 930, and the optical data connector 934 are illustratively mounted to the top side 750 of the chassis-less circuit board substrate 702. Again, as discussed above, any suitable attachment or mounting technology may be used to mount the electrical components of the storage sled 1300 to the chassis-less circuit board substrate 702 including, for example, sockets (e.g., a processor circuit socket), holders, brackets, soldered connections, and/or other mounting or securing techniques.

As discussed above, the individual storage controllers 1320 and the communication circuit 930 are mounted to the top side 750 of the chassis-less circuit board substrate 702 such that no two heat-producing, electrical components shadow each other. For example, the storage controllers 1320 and the communication circuit 930 are mounted in corresponding locations on the top side 750 of the chassis-less circuit board substrate 702 such that no two of those electrical components are linearly in-line with each other along the direction of the airflow path 708.

The memory devices 820 (not shown in FIG. 14) of the storage sled 1300 are mounted to the bottom side 850 (not shown in FIG. 14) of the chassis-less circuit board substrate 702 as discussed above in regard to the sled 500. Although mounted to the bottom side 850, the memory devices 820 are communicatively coupled to the storage controllers 1320 located on the top side 750 via the I/O subsystem 722. Again, because the chassis-less circuit board substrate 702 is implemented as a double-sided circuit board, the memory devices 820 and the storage controllers 1320 may be communicatively coupled by one or more vias, connectors, or other mechanisms extending through the chassis-less circuit board substrate 702. The storage controllers 1320 include and/or are associated with a heatsink 1370 secured thereto. As discussed above, due to the improved thermal cooling characteristics of the chassis-less circuit board substrate 702 of the storage sled 1300, none of the heatsinks 1370 include cooling fans attached thereto. That is, the heatsinks 1370 may be fan-less heatsinks.

Referring now to FIG. 15, in some examples, the sled 500 may be implemented as a memory sled 1500. The storage sled 1500 is optimized, or otherwise configured, to provide other sleds 500 (e.g., compute sleds 900, accelerator sleds 1100, etc.) with access to a pool of memory (e.g., in two or more sets 1530, 1532 of memory devices 820) local to the memory sled 1300. For example, during operation, a compute sled 900 or an accelerator sled 1100 may remotely write to and/or read from one or more of the memory sets 1530, 1532 of the memory sled 1300 using a logical address space that maps to physical addresses in the memory sets 1530, 1532. The memory sled 1500 includes various components similar to components of the sled 500 and/or the compute sled 900, which have been identified in FIG. 15 using the same reference numbers. The description of such components provided above in regard to FIGS. 7, 8, and 9 apply to the corresponding components of the memory sled 1500 and is not repeated herein for clarity of the description of the memory sled 1500.

In the illustrative memory sled 1500, the physical resources 720 include memory controllers 1520. Although only two memory controllers 1520 are shown in FIG. 15, it should be appreciated that the memory sled 1500 may include additional memory controllers 1520 in other examples. The memory controllers 1520 may be implemented as any type of programmable circuitry, controller, or control circuit capable of controlling the writing and reading of data into the memory sets 1530, 1532 based on requests received via the communication circuit 930. In the illustrative example, the memory controllers 1520 are connected to corresponding memory sets 1530, 1532 to write to and read from memory devices 820 (not shown) within the corresponding memory set 1530, 1532 and enforce any permissions (e.g., read, write, etc.) associated with sled 500 that has sent a request to the memory sled 1500 to perform a memory access operation (e.g., read or write).

In some examples, the memory sled 1500 may also include a controller-to-controller interconnect 1542. Similar to the resource-to-resource interconnect 724 of the sled 500 discussed above, the controller-to-controller interconnect 1542 may be implemented as any type of communication interconnect capable of facilitating controller-to-controller communications. In the illustrative example, the controller-to-controller interconnect 1542 is implemented as a high-speed point-to-point interconnect (e.g., faster than the I/O subsystem 722). For example, the controller-to-controller interconnect 1542 may be implemented as a QuickPath Interconnect (QPI), an UltraPath Interconnect (UPI), or other high-speed point-to-point interconnect dedicated to programmable circuitry-to-programmable circuitry communications. As such, in some examples, a memory controller 1520 may access, through the controller-to-controller interconnect 1542, memory that is within the memory set 1532 associated with another memory controller 1520. In some examples, a scalable memory controller is made of multiple smaller memory controllers, referred to herein as "chiplets," on a memory sled (e.g., the memory sled 1500). The chiplets may be interconnected (e.g., using Embedded Multi-Die Interconnect Bridge (EMIB) technology). The combined chiplet memory controller may scale up to a relatively large number of memory controllers and I/O ports, (e.g., up to 16 memory channels). In some examples, the memory controllers 1520 may implement a memory interleave (e.g., one memory address is mapped to the memory set 1530, the next memory address is mapped to the memory set 1532, and the third address is mapped to the memory set 1530, etc.). The interleaving may be managed within the memory controllers 1520, or from CPU sockets (e.g., of the compute sled 900) across network links to the memory sets 1530, 1532, and may improve the latency associated with performing memory access operations as compared to accessing contiguous memory addresses from the same memory device.

Further, in some examples, the memory sled 1500 may be connected to one or more other sleds 500 (e.g., in the same rack 340 or an adjacent rack 340) through a waveguide, using the waveguide connector 1580. In the illustrative example, the waveguides are 74 millimeter waveguides that provide 16 Rx (e.g., receive) lanes and 16 Tx (e.g., transmit) lanes. Different ones of the lanes, in the illustrative example, are either 16 gigahertz (GHz) or 32 GHz. In other examples, the frequencies may be different. Using a waveguide may provide high throughput access to the memory pool (e.g., the memory sets 1530, 1532) to another sled (e.g., a sled 500 in the same rack 340 or an adjacent rack 340 as the memory sled 1500) without adding to the load on the optical data connector 934.

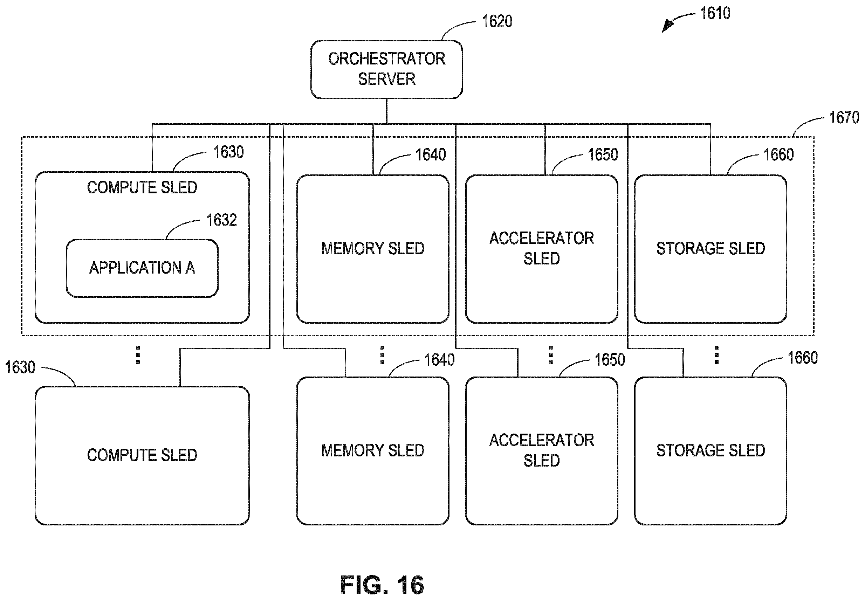

Referring now to FIG. 16, a system for executing one or more workloads (e.g., applications) may be implemented in accordance with the data center 200. In the illustrative example, the system 1610 includes an orchestrator server 1620, which may be implemented as a managed node including a compute device (e.g., programmable circuitry 920 on a compute sled 900) executing management software (e.g., a cloud operating environment, such as OpenStack) that is communicatively coupled to multiple sleds 500 including a large number of compute sleds 1630 (e.g., similar to the compute sled 900), memory sleds 1640 (e.g., similar to the memory sled 1500), accelerator sleds 1650 (e.g., similar to the memory sled 1500), and storage sleds 1660 (e.g., similar to the storage sled 1300). One or more of the sleds 1630, 1640, 1650, 1660 may be grouped into a managed node 1670, such as by the orchestrator server 1620, to collectively perform a workload (e.g., an application 1632 executed in a virtual machine or in a container). The managed node 1670 may be implemented as an assembly of physical resources 720, such as programmable circuitry 920, memory resources 820, accelerator circuits 1120, or data storage 1350, from the same or different sleds 500. Further, the managed node may be established, defined, or "spun up" by the orchestrator server 1620 at the time a workload is to be assigned to the managed node or at any other time, and may exist regardless of whether any workloads are presently assigned to the managed node. **In** the illustrative example, the orchestrator server 1620 may selectively allocate and/or deallocate physical resources 720 from the sleds 500 and/or add or remove one or more sleds 500 from the managed node 1670 as a function of quality of service (QoS) targets (e.g., a target throughput, a target latency, a target number of instructions per second, etc.) associated with a service level agreement for the workload (e.g., the application 1632). **In** doing so, the orchestrator server 1620 may receive telemetry data indicative of performance conditions (e.g., throughput, latency, instructions per second, etc.) in different ones of the sleds 500 of the managed node 1670 and compare the telemetry data to the quality of service targets to determine whether the quality of service targets are being satisfied. The orchestrator server 1620 may additionally determine whether one or more physical resources may be deallocated from the managed node 1670 while still satisfying the QoS targets, thereby freeing up those physical resources for use in another managed node (e.g., to execute a different workload). Alternatively, if the QoS targets are not presently satisfied, the orchestrator server 1620 may determine to dynamically allocate additional physical resources to assist in the execution of the workload (e.g., the application 1632) while the workload is executing. Similarly, the orchestrator server 1620 may determine to dynamically deallocate physical resources from a managed node if the orchestrator server 1620 determines that deallocating the physical resource would result in QoS targets still being met.

Additionally, in some examples, the orchestrator server 1620 may identify trends in the resource utilization of the workload (e.g., the application 1632), such as by identifying phases of execution (e.g., time periods in which different operations, having different resource utilizations characteristics, are performed) of the workload (e.g., the application 1632) and pre-emptively identifying available resources in the data center 200 and allocating them to the managed node 1670 (e.g., within a predefined time period of the associated phase beginning). In some examples, the orchestrator server 1620 may model performance based on various latencies and a distribution scheme to place workloads among compute sleds and other resources (e.g., accelerator sleds, memory sleds, storage sleds) in the data center 200. For example, the orchestrator server 1620 may utilize a model that accounts for the performance of resources on the sleds 500 (e.g., FPGA performance, memory access latency, etc.) and the performance (e.g., congestion, latency, bandwidth) of the path through the network to the resource (e.g., FPGA). As such, the orchestrator server 1620 may determine which resource(s) should be used with which workloads based on the total latency associated with different potential resource(s) available in the data center 200 (e.g., the latency associated with the performance of the resource itself in addition to the latency associated with the path through the network between the compute sled executing the workload and the sled 500 on which the resource is located).

In some examples, the orchestrator server 1620 may generate a map of heat generation in the data center 200 using telemetry data (e.g., temperatures, fan speeds, etc.) reported from the sleds 500 and allocate resources to managed nodes as a function of the map of heat generation and predicted heat generation associated with different workloads, to maintain a target temperature and heat distribution in the data center 200. Additionally or alternatively, in some examples, the orchestrator server 1620 may organize received telemetry data into a hierarchical model that is indicative of a relationship between the managed nodes (e.g., a spatial relationship such as the physical locations of the resources of the managed nodes within the data center 200 and/or a functional relationship, such as groupings of the managed nodes by the customers the managed nodes provide services for, the types of functions typically performed by the managed nodes, managed nodes that typically share or exchange workloads among each other, etc.). Based on differences in the physical locations and resources in the managed nodes, a given workload may exhibit different resource utilizations (e.g., cause a different internal temperature, use a different percentage of programmable circuitry or memory capacity) across the resources of different managed nodes. The orchestrator server 1620 may determine the differences based on the telemetry data stored in the hierarchical model and factor the differences into a prediction of future resource utilization of a workload if the workload is reassigned from one managed node to another managed node, to accurately balance resource utilization in the data center 200. In some examples, the orchestrator server 1620 may identify patterns in resource utilization phases of the workloads and use the patterns to predict future resource utilization of the workloads.

To reduce the computational load on the orchestrator server 1620 and the data transfer load on the network, in some examples, the orchestrator server 1620 may send self-test information to the sleds 500 to enable a given sled 500 to locally (e.g., on the sled 500) determine whether telemetry data generated by the sled 500 satisfies one or more conditions (e.g., an available capacity that satisfies a predefined threshold, a temperature that satisfies a predefined threshold, etc.). The given sled 500 may then report back a simplified result (e.g., yes or no) to the orchestrator server 1620, which the orchestrator server 1620 may utilize in determining the allocation of resources to managed nodes.

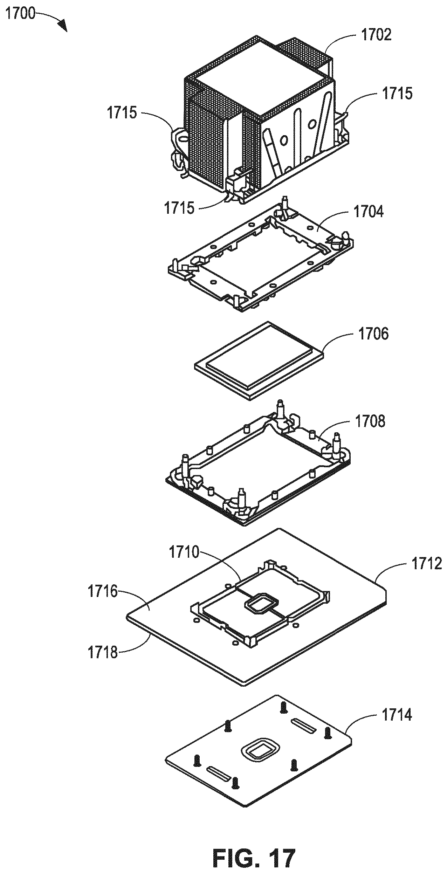

FIG. 17 illustrates an exploded view of an example integrated circuit (IC) package heat dissipating component stack 1700 in which examples disclosed herein may be implemented. In FIG. 17, the component stack 1700 includes a heatsink 1702, a carrier (e.g., a package carrier, a carrier plate) 1704, an integrated circuit (IC) package 1706, a bolster plate 1708, a socket 1710 coupled to a printed circuit board (PCB) (e.g., a motherboard) 1712, and a back plate 1714. The example IC package heat dissipating component stack 1700 can be implemented in any of the example data centers 102, 106, 116, 200 and/or building(s) 110 of FIGS. 1 and/or 2. More particularly, in some examples, the IC package heat dissipating component stack 1700 is implemented on one or more of any of the example sleds 500, 900, 1100, 1300, 1500 of FIGS. 5-15 and/or on any other server.

In this example, the IC package 1706 includes one or more electrical circuits on a semiconductor substrate. In some examples, the IC package 1706 can perform processing functions, memory functions, and/or any other suitable functions. The IC package 1706 can include any type of processing circuitry, including programmable microprocessors, one or more FPGAs, one or more CPUs, one or more GPUs, one or more DSPs, one or more XPUs, one or more ASICs, and/or one or more microcontrollers. In FIG. 17, the IC package 1706 is a land grid array (LGA) processor chip. Additionally or alternatively, the IC package 1706 can be one of a ball grid array (BGA) processor chip or a pin grid array (PGA) processor chip instead. Further, other types of IC packages can be used in the component stack 1700 instead of a processor chip (e.g., a memory chip). In FIG. 17, the carrier 1704 is used to couple the heatsink 1702 to the IC package 1706 prior to assembly of the entire component stack 1700. In some examples, the carrier 1704 is omitted and the assembly process involves inserting the IC package 1706 into the socket 1710 and then attaching the heatsink 1702.

In FIG. 17, the heatsink 1702 is couplable (e.g., thermally couplable) to the IC package 1706 to dissipate heat therefrom. In FIG. 17, the heatsink 1702 is mechanically coupled to the back plate 1714 via fixture elements, loading mechanisms, or fasteners 1715 to place the components between the heatsink 1702 and the back plate 1714 within the component stack 1700 in compression when assembled. In some examples, the heatsink 1702 is coupled to the back plate 1714 via the bolster plate 1708 positioned therebetween. More particularly, as shown in FIG. 17, the bolster plate 1708 is couplable to a top surface 1716 of the PCB 1712 while the back plate 1714 is couplable to a bottom surface 1718 of the PCB 1712 opposite the bolster plate 1708. In this manner, the PCB 1712 is sandwiched between the bolster plate 1708 and the back plate 1714. The bolster plate 1708 is constructed to surround the socket 1710 positioned on the top surface 1716 of the PCB 1712.

The socket 1710 communicatively couples the IC package 1706 to the printed circuit board 1712. In FIG. 17, the socket 1710 is an LGA socket, which includes a plurality of pins within the socket arranged to interface (e.g., electrically couple) with corresponding contacts/lands/pads on the IC package 1706. In other examples, the socket 1710 can be implemented by any other type of socket (e.g., a BGA, a PGA, etc.) suitable to receive and interface with the IC package 1706. The compression created by the mechanical coupling of the heatsink 1702 to the back plate 1714 via the fasteners 1715 serves to ensure that corresponding connectors (e.g., pins, lands, etc.) on the socket 1710 and the IC package 1706 remain in contact.

The socket 1710 includes datum walls that guide the IC package 1706 into place during assembly. Typically, the IC package 1706 contacts the datum walls as the IC package 1706 is positioned into place. However, the socket 1710 is made from a liquid crystal polymer (LCP) material that is relatively brittle and/or weak. As such, the datum walls of the socket 1710 are susceptible to breaking or shearing during the alignment/assembly process. In some examples, the portions of the datum wall (e.g., pieces of the LCP material) chip or shear off of the socket 1710. This chipping of material due to contact between the IC package 1706 and the datum walls of the socket 1710 is also referred to herein as "skiving." The debris material from skiving can negatively impact the performance of the IC package 1706 by causing misalignment between the IC package 1706 (e.g., the contacts on the IC package 1706) and the underlying pins on the socket 1710.

Examples disclosed herein provide protrusions in socket designs that mitigate skiving of socket walls (e.g., when an IC package is positioned/assembled thereon). Examples disclosed herein include metal to strengthen socket walls to limit and/or prevent skiving. As such, examples disclosed herein ensure that little to no LCP material is removed from the socket wall, wedges between the socket and the IC package, disrupts the alignment between contacts of the IC package and the pins on the socket, etc. Thus, examples disclosed herein protect the IC package from negative impacts to electrical performance that would otherwise have been caused by misalignment with the pins of the socket. Further, disclosed examples utilize metal components such as metal shields that enable flexibility and/or adaptability in socket designs. For example, disclosed examples enable datum walls to be taller, wider, and/or include sharper chamfer angles usable with various types of sockets and/or IC packages.

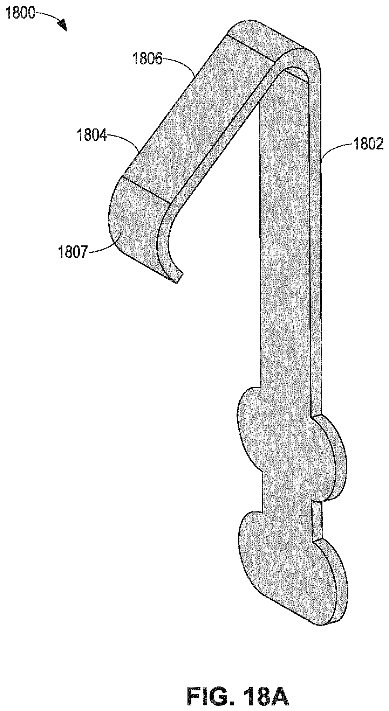

FIG. 18A illustrates an example metal component 1800 constructed in accordance with teachings of this disclosure. In some examples, the metal component 1800 includes copper. In FIG. 18A, the example metal component 1800 includes an example first arm 1802 (e.g., portion) and an example second arm 1804 extending away from the first arm 1802. The example second arm 1804 is an integral extension of the first arm 1802. Further, the example second arm 1804 includes an example first chamfered surface 1806. In this example, the second arm 1804 includes an example curved free end 1807.

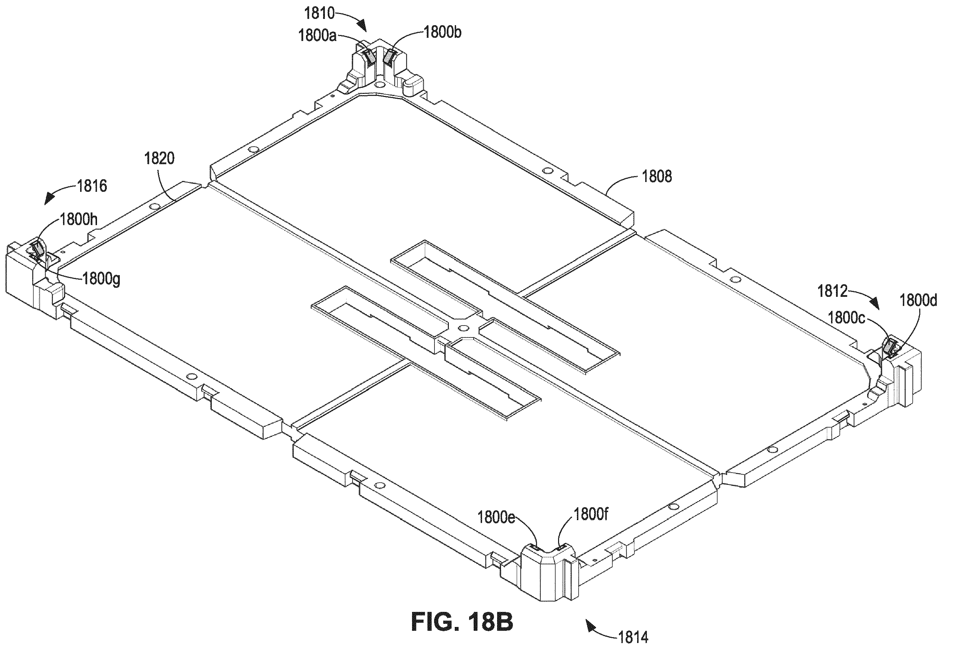

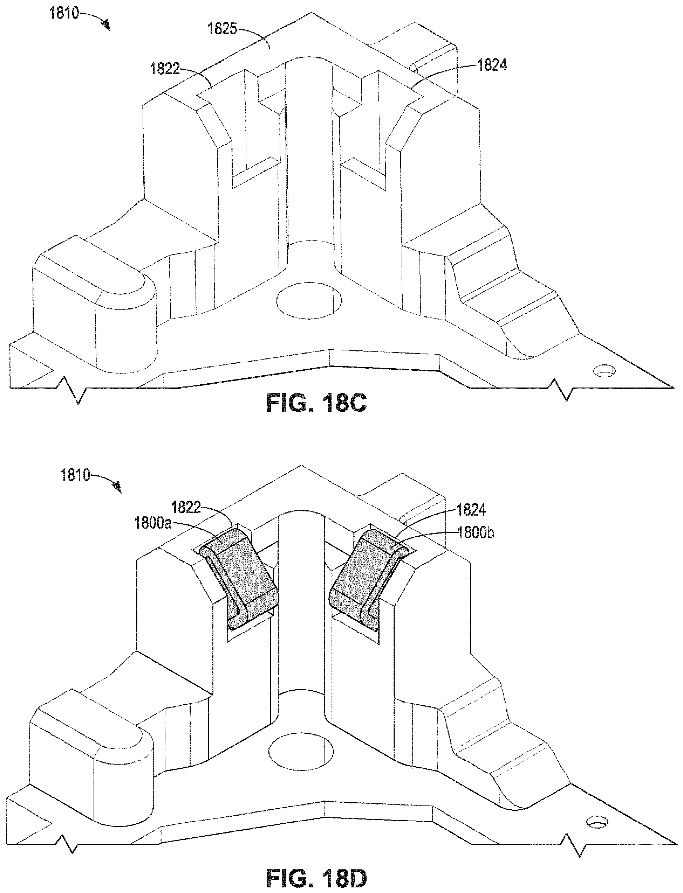

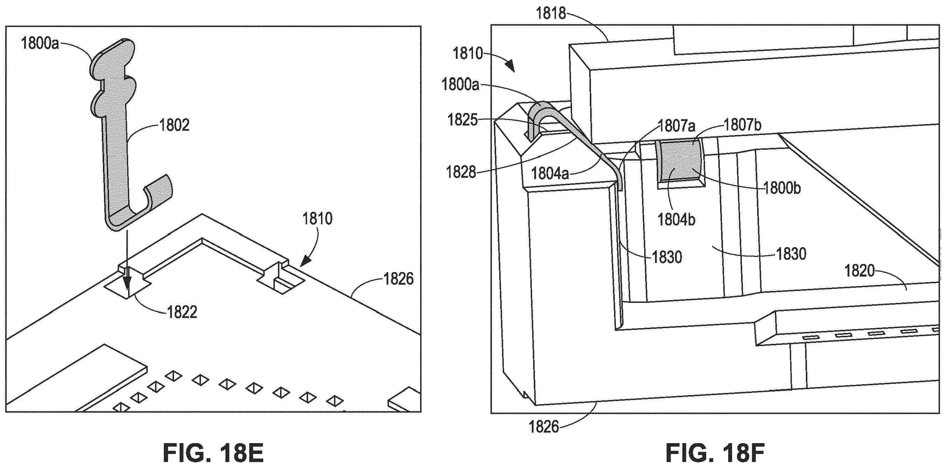

FIG. 18B illustrates an example socket body 1808 constructed in accordance with teachings of this disclosure. The example socket body 1808 of FIG. 18B includes multiple metal components 1800a-1800h distributed at example protrusions 1810, 1812, 1814, 1816 of the socket body 1808. FIG. 18C is a detailed view of the example protrusion 1810 of the socket body 1808 having removed the metal components 1800a, 1800b for purposes of explanation. FIG. 18D is a detailed view of the example protrusion 1810 including the metal components 1800a, 1800b. FIG. 18E is an exploded view of the example protrusion 1810 of the socket body 1808 from a backside (e.g., bottom side) to show the assembly or insertion of the metal component 1800a into the socket body 1808. FIG. 18F is an assembled view of the example protrusion 1810 of the socket body 1808, the metal components 1800a, 1800b, and an example IC package 1818.

The example socket body 1808 of FIGS. 18B-18F includes a plastic material. As used herein, the term "plastic" refers to any pliable, moldable, shapable, etc., material. In some examples, the plastic material is LCP. Further, an array of contacts (not included in FIG. 18B for purposes of explanation) can be distributed across an example surface 1820 of the socket body 1808. As shown in FIG. 18B, example protrusions 1810, 1812, 1814, 1816 extend away from the surface 1820. The example protrusions 1810, 1812, 1814, 1816 include metal portions (e.g., the metal components 1800a-1800h) and plastic portions (e.g., walls of the socket body 1808, integral extensions of the socket body 1808, etc.). The example protrusions 1810, 1812, 1814, 1816 facilitate alignment of the IC package 1818 with the array of contacts.

In FIG. 18B, the example metal components 1800a, 1800b are positioned at the protrusion 1810, the metal components 1800c, 1800d are positioned at the protrusion 1812, the metal components 1800e, 1800f are positioned at the protrusion 1814, and the metal components 1800g, 1800h are positioned at the protrusion 1816. As shown in FIGS. 18C and 18D, the example metal components 1800a, 1800b are positioned in example cavities 1822, 1824 defined by the plastic portion of the protrusion 1810. For example, the first arm 1802 (FIG. 18A) of the metal component 1800a extends through the cavity 1822 (e.g., in a first direction) and the first arm 1802 of the metal component 1800b extends through the cavity 1824. As such, the first arms 1802 of the metal components 1800a, 1800b are surrounded by the plastic portion of the protrusion 1810. Further, the second arm 1804a of the metal component 1800a extends away from the first arm 1802 (e.g., in a second direction transverse to the first direction). Similarly, the second arm 1804b of the metal component 1800b extends away from the first arm 1802.

In FIG. 18E, the example metal component 1800a is shown disassembled from the protrusion 1810 (e.g., prior to assembly). During assembly, the example metal component 1800a is routed, pushed, deposited, etc., through the cavity 1822 from a backside (e.g., bottom side) of the socket body 1808. The example cavity 1822 extends from a top surface 1825 (FIG. 18F) to an example opposing surface 1826 (e.g., a bottom side of the socket body 1808). In some examples, when assembled/inserted within the socket body 1808, the second arms 1804a, 1804b of the metal components, 1800a, 1800b extend beyond (e.g., above) the top surface 1820 of the protrusion 1810 and an example adjacent chamfered or angled surface 1828 of the protrusion 1810. As a result, as shown in FIG. 18F, the second arms 1804a, 1804b of the metal components 1800a, 1800b interface with the IC package 1818 before the IC package 1818 interfaces with the plastic portions of the socket body 1808 (e.g., as the IC package 1818 is inserted into the socket body 1808). Likewise, in some examples, the free ends 1807a, 1807b of the second arms 1804a, 1804b protrude beyond (e.g., laterally inward from) example inner facing sidewalls 1830 of the protrusion 1810 to interface with the IC package 1818 before the socket body 1808 interfaces with the IC package 181 (e.g., when the IC package 1818 approaches from a lateral direction). In some examples, the second arms 1804a, 1804b deflect as they interface with the IC package 1818 until the IC package 1818 comes into contact with the plastic portions of the socket body 1808. However, at least some of the force of such contact is absorbed by the deflection of the second arms 1804a, 1804b to reduce negative impacts on the plastic portions of the socket body 1808.

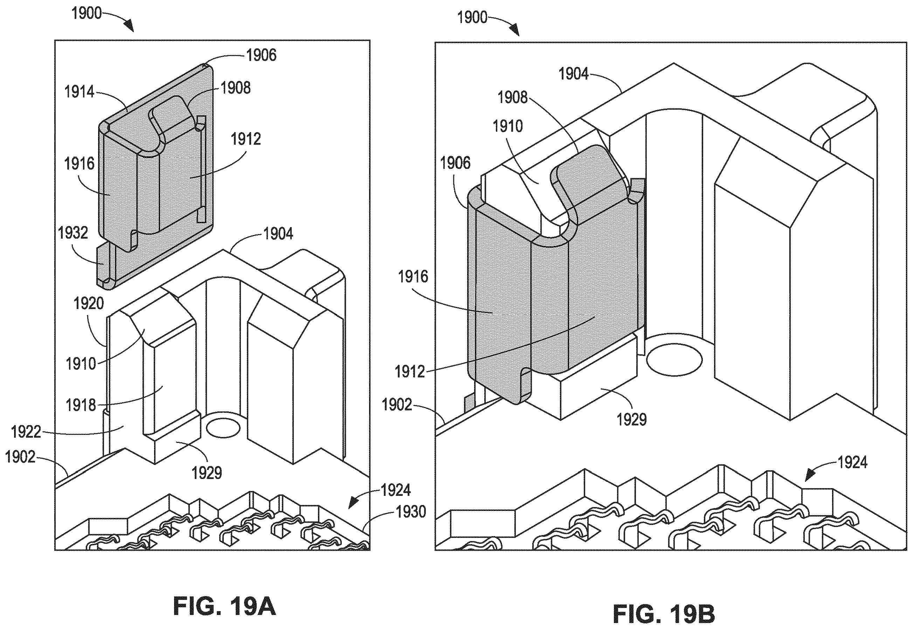

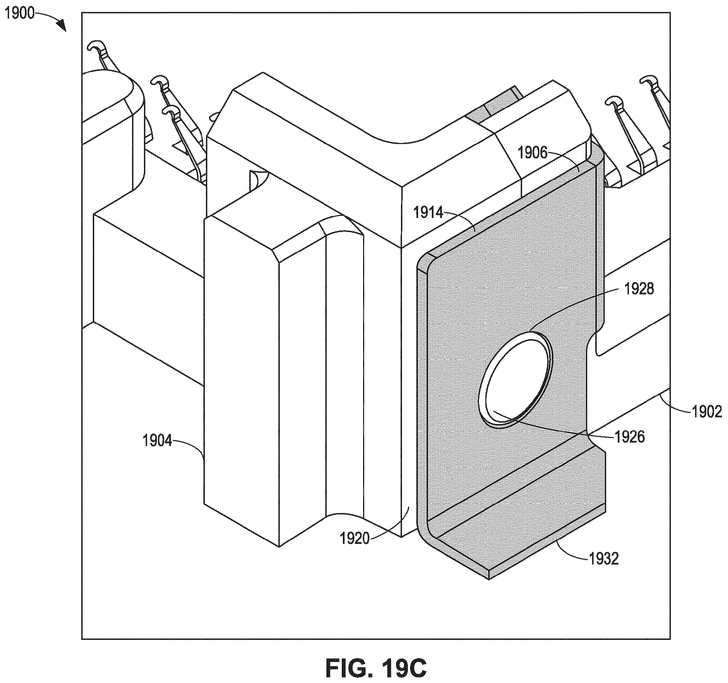

FIGS. 19A-19C illustrate another example protrusion 1900 of an example socket body 1902 constructed in accordance with examples disclosed herein. The example protrusion 1900 includes an example plastic portion 1904 surrounded by an example metal sheath 1906. In some examples, the metal sheath 1906 includes copper. The example socket body 1902 of FIGS. 19A-19C is similar to the example socket body 1808 of FIGS. 18B-18F. However, the example socket body 1902 does not include cavities fitted to receive metal components. Alternatively, the example metal sheath 1906 provides an example second chamfered surface 1908 adjacent an example third chamfered surface 1910 of the plastic portion 1904 to facilitate IC package alignment with the socket body 1902. In particular, the example second chamfered surface 1908 covers the third chamfered surface 1910.

The example metal sheath 1906 includes example first, second, and third panels 1912, 1914, 1916 that are connected. The example first, second, and third panels 1912, 1914, 1916 wrap around example first, second, and third sides 1918, 1920, 1922 of the plastic portion 1904 of the protrusion 1900. The example first side 1918 faces towards an example array of contacts 1924. The example second side 1920 opposes the first side 1918. The example third side 1922 extends between the first and second sides 1918, 1920. The example first and second panels 1912, 1914 are adjacent (e.g., cover) the respective first and second sides 1918, 1920 of the plastic portion 1904. The example second side 1920 includes an example button 1926 (e.g., knob, nub, bump, jut, projection, etc.) extending away from the second side 1920. The example button 1926 extends into and/or through an example opening 1928 in the second panel 1914. As such, the example metal sheath 1906 is coupled to the socket body 1902 via a coupling between the button 1926 and the opening 1928 of the metal sheath 1906.

In this example, the metal sheath 1906 includes three panels 1912, 1914, 1916. However, the metal sheath 1906 can include at least one panel (e.g., the first panel 1912) to cover at least one side (e.g., the first side 1918) of the plastic portion 1904. In some examples, at least part of the first side 1918 (e.g., a bottom portion 1929 in this example) is not covered by the first panel 1912. The at least part of the example first side 1918 is closer to an example surface 1930 of the socket body 1902 than the first panel 1912 is to the surface 1930. In some examples, the portion of the first side 1918 that is covered by the first panel 1912 is recessed relative to the at least part of the first side 1918 that is not covered by the first panel 1912 so that the first panel 1912 of the sheath 1906 is approximately flush with the portion that is not covered. The example metal sheath 1906 includes an example tab 1932 positioned along a plane that extends transverse to the first and second panels 1912, 1914. The example tab 1932 is to interface with a surface of a PCB (e.g., the socket body 1902 to be mounted on the surface of the PCB). That is, in some examples, the sheath 1906 is constructed so that the bottom side of the tab 1932 is to be approximately flush with the bottom surface of the socket body 1902 when the sheath 1906 is coupled to the socket body 1902.

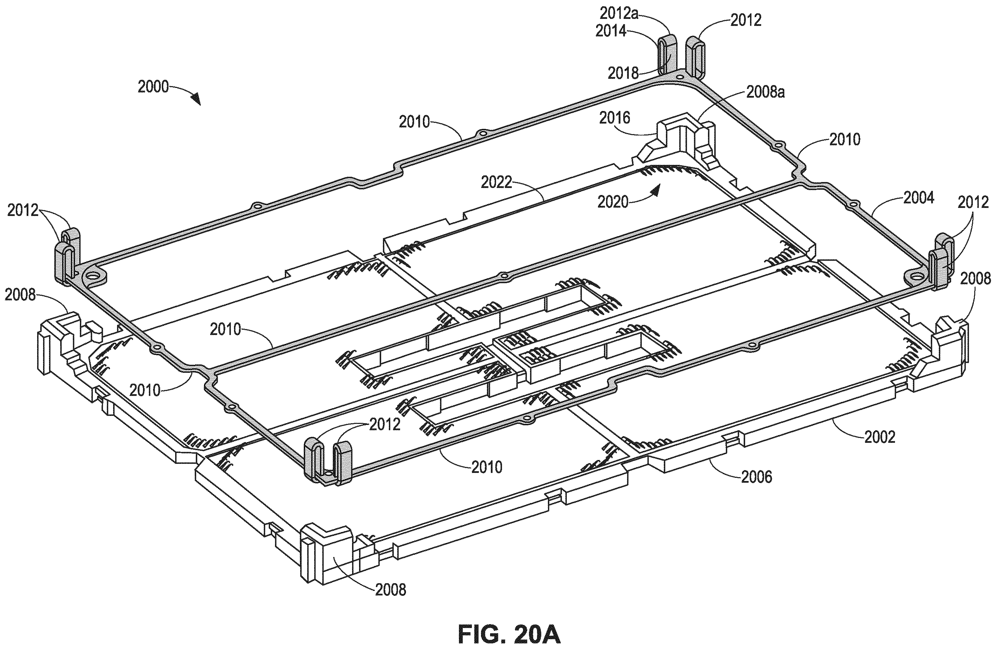

FIG. 20A is an exploded view of an example assembly 2000 constructed in accordance with examples disclosed herein. The example assembly 2000 includes an example socket body 2002 and an example metal frame 2004. The example socket body 2002 includes an example base 2006 and example plastic protrusions 2008. The example metal frame 2004 includes example branches 2010 and example metal protrusions 2012. In some examples, the metal frame 2004, the branches 2010, and/or the metal protrusions 2012 include stainless steel. The example branches 2010 of the metal frame 2004 are embedded in (e.g., overmolded by) the base 2006 of the socket body 2002 (e.g., in an assembled position). That is, in some examples, the socket body 2002 and the metal frame 2004 are not separately fabricated and then combined together. Rather, the assembly involves fabricating the metal frame 2004 first, and then fabricating the socket body 2002 around the metal frame 2004 through a molding process.

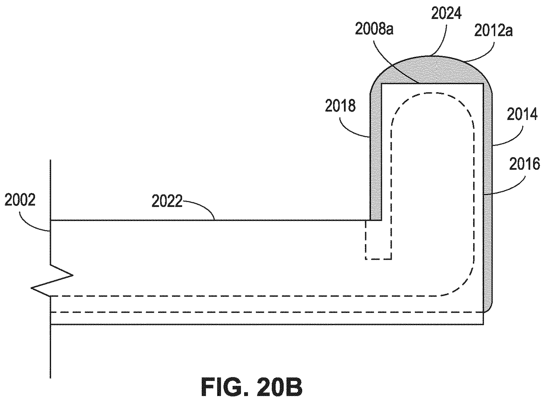

FIG. 20B is an assembled, side view of the example metal protrusion 2012a and the plastic protrusion 2008a of FIG. 20A. However, the examples described with reference to FIG. 20B are not intended to appear or match exactly as shown in FIG. 20A. Rather, the side view of FIG. 20B is intended to generally describe the positioning of the metal protrusion 2012a relative to the plastic protrusion 2008a in an assembled position. The example metal protrusion 2012a at least partially surrounds the plastic protrusion 2008a. Further, the example metal protrusion 2012a is at least partially embedded in the plastic protrusion 2008a. The example metal protrusion 2012a includes an example first side 2014 (e.g., back side) facing away from an example surface 2016 of the plastic protrusion 2008a. Further, the example metal protrusion 2012a includes an example second side 2018 facing an example array of contacts 2020 (FIG. 20A) distributed across an example surface 2022 (FIG. 20A) of the socket body 2002. As shown in FIG. 20B, an example curved portion 2024 of the metal protrusion 2012a covers (e.g., wraps around) an end (e.g., a top end) of the plastic protrusion 2008a. The example metal protrusion 2012a extends away from the surface 2022. The example metal protrusions 2012 guide movement of an example IC package relative to the array of contacts 2020. In other words, the example metal protrusion 2012a includes at least one metal surface to facilitate a positioning of the IC package relative to at least one contact in the array of contacts 2020.

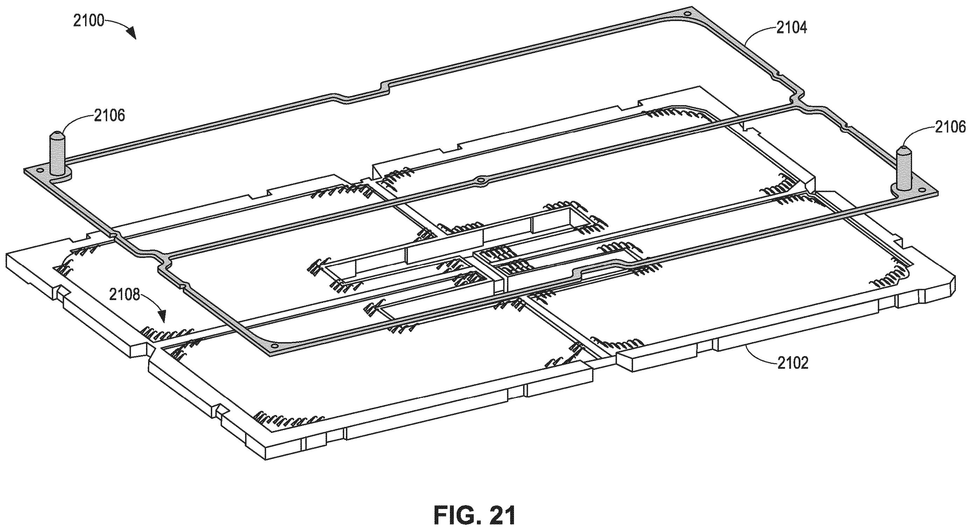

FIG. 21 is an exploded view of an example assembly 2100 constructed in accordance with examples disclosed herein. The example assembly 2100 includes an example socket body 2102, an example metal frame 2104, and example metal posts 2106. In some examples, the metal frame 2104 and/or the metal posts 2106 include stainless steel. The example metal posts 2106 are attached to and/or mounted on the metal frame 2104. Further, the example metal posts 2106 extend/protrude away from the metal frame 2104. When the example assembly 2100 is assembled, the metal frame 2104 is embedded within the socket body 2102. In other words, the example metal frame 2104 is overmolded by (e.g., surrounded by) the socket body 2102. In turn, the example metal posts 2106 extend/protrude away from the socket body 2102 (e.g., in an assembled position). The example metal posts 2106 guide movement of an example IC package relative to an array of contacts 2108.

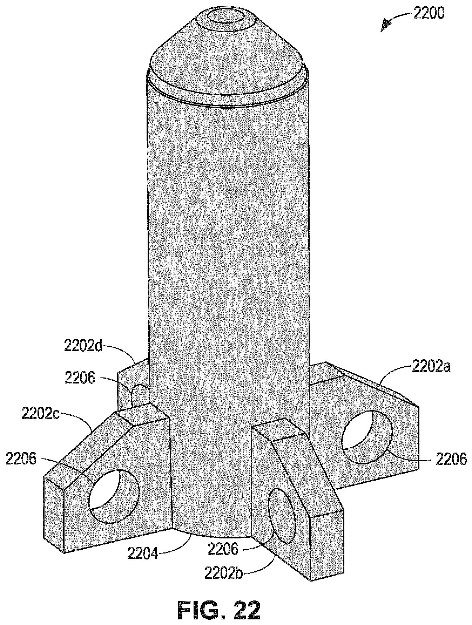

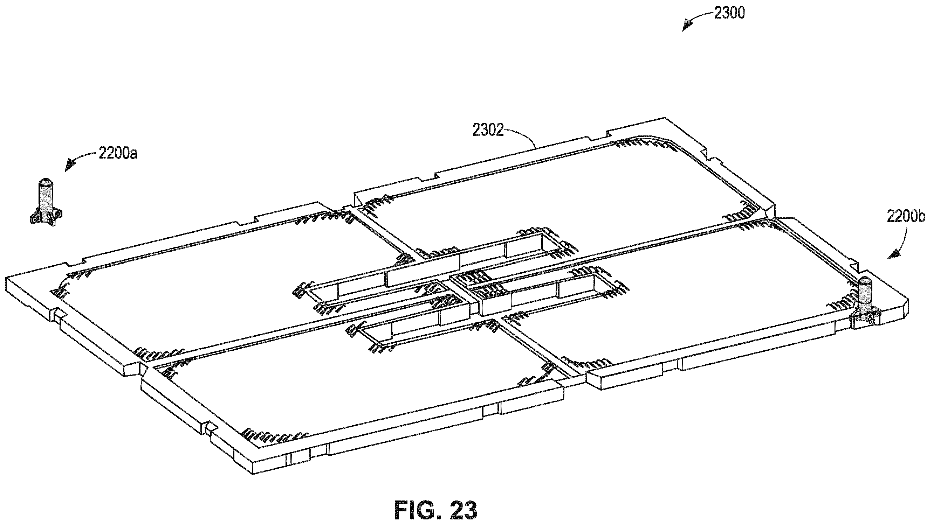

FIG. 22 illustrates an example metal post 2200 constructed in accordance with teachings of this disclosure. In some examples, the metal post 2200 includes stainless steel. The example metal post 2200 includes example flanges 2202a-2202d adjacent an example end 2204 of the metal post 2200. The example flanges 2202a-2202d include example holes 2206. FIG. 23 illustrates a partially assembled view of an example assembly 2300 constructed in accordance with examples disclosed herein. The example assembly 2300 includes two example metal posts 2200a, 2200b. The example flanges 2202a-2202d couple the corresponding metal posts 2200a, 2200b to an example socket body 2302. The example socket body 2302 includes a plastic material that extends through the holes 2206 (e.g., in an assembled position). That is, during a molding process, the plastic for the example socket body 2302 flows through the holes 2206 to help retain the posts 2200a, 2200b in position without the need for the posts 2200a, 2200b to be connected to a metal frame (unlike what is shown in FIG. 21). In some examples, the metal posts 2200a, 2200b are positioned on a surface of the socket body 2302. In such examples, the flanges 2202a-2202d are positioned on the surface of the socket body 2302 (e.g., unlike what is shown in FIG. 23). In some examples, the metal posts 2200a, 2200b are surface mounted to an underlying PCB (e.g., the PCB 1712 of FIG. 17). In such examples, the flanges 2202a-2202d are surface mounted to the underlying PCB and the metal posts 2200a, 2200b extend through the socket body 2302.

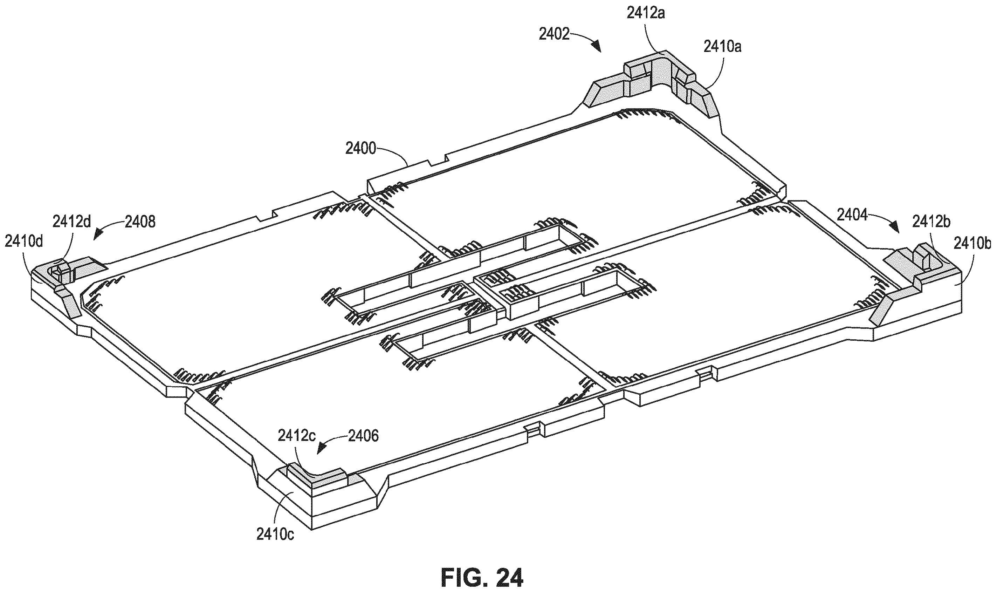

FIG. 24 illustrates an example socket body 2400 constructed in accordance with examples disclosed herein. The example socket body 2400 includes example protrusions 2402, 2404, 2406, 2408. The example protrusions 2402, 2404, 2406, 2408 include plastic portions 2410a-2410d (e.g., integral extensions of the socket body 2400) and metal portions 2412a-2412d (e.g., shaded regions of FIG. 24). In the example of FIG. 24, the metal portions 2412a-2412d are a metal coating that covers the plastic portions 2410a-2410d. In some examples, the metal coating is applied to the plastic portions 2410a-2410b through a physical vapor deposition process. In some examples, the metal coating includes at least one of aluminum, nickel, copper, etc. In some examples, the metal coating is applied via vacuum metallization or electroless plating.

In some examples, the metal components 1800a-1800h, the metal sheath 1906, the metal frame 2004, the metal frame 2104, the metal posts 2200a, 2200b, or the metal portions 2412a-2412d are coupled (e.g., via a solder connection or via a direct connection) to a ground. For example, any of the example sockets disclosed herein include ground pins. The example metal components 1800a-1800h, the metal sheath 1906, the metal frame 2004, the metal frame 2104, the metal posts 2200a, 2200b, or the metal portions 2412a-2412d are coupled to ground via an example ground pin on a corresponding socket. Further, any of the example IC packages disclosed herein include ground pins. In some examples, the metal components 1800a-1800h, the metal sheath 1906, the metal frame 2004, the metal frame 2104, the metal posts 2200a, 2200b, or the metal portions 2412a-2412d are coupled to a ground on a corresponding IC package and a corresponding socket.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example, an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that provide protrusions in socket designs that mitigate skiving of socket walls (e.g., when an IC package is positioned/assembled thereon). Examples disclosed herein include metal to strengthen socket walls to limit and/or prevent skiving. As such, examples disclosed herein ensure that little to no plastic material is removed from the socket wall, wedges between the socket and the IC package, disrupts the alignment between contacts of the IC package and the pins on the socket, etc. Thus, examples disclosed herein protect the IC package from negative impacts to electrical performance that would otherwise have been caused by misalignment with the pins of the socket. Further, disclosed examples utilize metal components such as metal shields that enable flexibility and/or adaptability in socket designs. For example, disclosed examples enable datum walls to be taller, wider, and/or include sharper chamfer angles usable with various types of sockets and/or IC packages.

Example 1 includes an apparatus comprising a socket body, the socket body including a plastic material, an array of contacts distributed across a surface of the socket body, and a protrusion extending away from the surface of the socket body, the protrusion to facilitate alignment of an IC package with the array of contacts, the protrusion including metal.

Example 2 includes the apparatus of example 1, wherein a first portion of the protrusion includes the plastic material and a second portion of the protrusion includes the metal, the first portion of the protrusion an integral extension of the socket body.

Example 3 includes the apparatus of example 1 or example 2, wherein the second portion is to interface with the IC package before the IC package interfaces with the first portion as the IC package is inserted into the socket body.

Example 4 includes the apparatus of any of examples 1-3, wherein the second portion is surrounded by the first portion.

Example 5 includes the apparatus of any of examples 1-4, wherein the second portion extends in a first direction through a cavity defined by the first portion of the protrusion, further including a third portion of the protrusion including metal, the third portion an integral extension of the second portion, the third portion extending away from the first portion in a second direction transverse to the first direction.

Example 6 includes the apparatus of any of examples 1-5, wherein the second portion at least partially surrounds the first portion.

Example 7 includes the apparatus of any of examples 1-6, wherein the second portion is a metal coating on the first portion.

Example 8 includes the apparatus of any of examples 1-7, wherein the second portion is a metal sheath, the metal sheath including at least one panel to cover at least one side of the first portion of the protrusion.

Example 9 includes the apparatus of any of examples 1-8, wherein the metal sheath includes three connected panels to wrap around three sides of the first portion of the protrusion, the three sides including a first side, a second side, and a third side, the first side facing towards the array of contacts, the second side opposing the first side, the third side extending between the first and second sides.

Example 10 includes the apparatus of any of examples 1-9, wherein the three connected panels of the metal sheath include first and second panels adjacent the respective first and second sides of the first portion of the protrusion, the second side including a button extending away from the second side, the button to extend through an opening in the second panel of the metal sheath.

Example 11 includes the apparatus of any of examples 1-10, wherein the metal sheath includes a tab positioned along a plane that extends transverse to the first and second panels of the metal sheath, the tab to interface with a surface of a printed circuit board, the socket body to be mounted to the surface of the printed circuit board.

Example 12 includes the apparatus of any of examples 1-11, wherein the three connected panels of the metal sheath include a first panel that covers the first side of the first portion of the protrusion, at least part of the first side is not covered by the first panel, the at least part of the first side closer to the surface of the socket body than the first panel is to the surface of the socket body.

Example 13 includes the apparatus of any of examples 1-13, wherein the first side of the first portion of the protrusion includes a first chamfered surface, and the metal sheath includes a second chamfered surface to cover the first chamfered surface.

Example 14 includes a socket to interface with an integrated circuit (IC) package, the socket comprising a plastic body, a metal surface extending away from the plastic body, the metal surface to engage with the IC package to facilitate a positioning of the IC package relative to at least one contact carried by the plastic body.

Example 15 includes the socket of example 14, further including a metal post, the metal post defining the metal surface.

Example 16 includes the socket of example 14 or example 15, wherein the metal post is attached to a metal frame, the metal frame embedded within the plastic body.

Example 17 includes the socket of any of examples 14-16, wherein the metal post includes flanges to couple the metal post to the plastic body, the flanges including holes, a material of the plastic body extending through the holes.

Example 18 includes an apparatus comprising a printed circuit board, and a socket positioned on the printed circuit board, the socket to receive an integrated circuit (IC) package, the socket including an array of contacts distributed across a surface of the socket, and a wall defined by metal, the wall to guide movement of the IC package relative to the array of contacts.

Example 19 includes the apparatus of example 18, wherein the wall includes a chamfered surface.

Example 20 includes the apparatus of example 18 or example 19, wherein the wall is a first wall and the chamfered surface is a first chamfered surface, and the socket includes a second wall defined by plastic, the second wall including a second chamfered surface adjacent the first chamfered surface.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An apparatus comprising:
a socket body, the socket body including a plastic material;
an array of contacts distributed across a surface of the socket body; and
a protrusion extending away from the surface of the socket body, the protrusion to facilitate alignment of an IC package with the array of contacts, the protrusion including metal.

2. The apparatus of claim 1, wherein a first portion of the protrusion includes the plastic material and a second portion of the protrusion includes the metal, the first portion of the protrusion an integral extension of the socket body.

3. The apparatus of claim 2, wherein the second portion is to interface with the IC package before the IC package interfaces with the first portion as the IC package is inserted into the socket body.

4. The apparatus of any one of claims 2-3, wherein the second portion is surrounded by the first portion.

5. The apparatus of claim 4, wherein the second portion extends in a first direction through a cavity defined by the first portion of the protrusion, further including a third portion of the protrusion including metal, the third portion an integral extension of the second portion, the third portion extending away from the first portion in a second direction transverse to the first direction.

6. The apparatus of any one of claims 2-3, wherein the second portion at least partially surrounds the first portion.

7. The apparatus of claim 6, wherein the second portion is a metal coating on the first portion.

8. The apparatus of claim 6, wherein the second portion is a metal sheath, the metal sheath including at least one panel to cover at least one side of the first portion of the protrusion.

9. The apparatus of claim 8, wherein the metal sheath includes three connected panels to wrap around three sides of the first portion of the protrusion, the three sides including a first side, a second side, and a third side, the first side facing towards the array of contacts, the second side opposing the first side, the third side extending between the first and second sides.

10. The apparatus of claim 9, wherein the three connected panels of the metal sheath include first and second panels adjacent the respective first and second sides of the first portion of the protrusion, the second side including a button extending away from the second side, the button to extend through an opening in the second panel of the metal sheath.

11. The apparatus of claim 10, wherein the metal sheath includes a tab positioned along a plane that extends transverse to the first and second panels of the metal sheath, the tab to interface with a surface of a printed circuit board, the socket body to be mounted to the surface of the printed circuit board.

12. The apparatus of claim 9, wherein the three connected panels of the metal sheath include a first panel that covers the first side of the first portion of the protrusion, at least part of the first side is not covered by the first panel, the at least part of the first side closer to the surface of the socket body than the first panel is to the surface of the socket body.

13. The apparatus of claim 9, wherein the first side of the first portion of the protrusion includes a first chamfered surface, and the metal sheath includes a second chamfered surface to cover the first chamfered surface.

14. An integrated circuit package including the apparatus of any one of claims 1-13.

15. An electronic device including the integrated circuit package of claim 14.
